# EUROPEAN PATENT APPLICATION

(11) **EP 4 730 943 A1**
(43) Date of publication of application: **22.04.2026**
(21) Application number: 25201079.8
(22) Date of filing: 09.09.2025
(51) Int. Cl.: H10B 12/00, H10D 30/67, H10D 64/27

(54) **SEMICONDUCTOR DEVICE**

(30) Priority: 15.10.2024 KR 20240140573
(71) Applicant: Samsung Electronics Co., Ltd., Suwon-si, Gyeonggi-do 16677 (KR)
(72) Inventor: YANG, Minwoo, 16677 Suwon-si (KR); KIM, Sukhoon, 16677 Suwon-si (KR); LYU, Sungnam, 16677 Suwon-si (KR)
(74) Representative: Marks & Clerk LLP

(57) **Abstract**

Provided is a semiconductor device including a bit line (BO), a data storage structure (DS) spaced apart from the bit line along a first direction (D2), a word line structure (WO) between the bit line and the data storage structure, a first channel pattern (CL, CL1) electrically connecting the bit line and the data storage structure, and a gate insulating layer (21) including an interposed portion (IN) between the word line structure and the first channel pattern. The word line structure includes a gate pattern (52), an insulating pattern (53) between the gate pattern and the bit line, and a work-function pattern (51) between the gate pattern and the data storage structure.

## Description

### BACKGROUND

The present disclosure herein relates to semiconductor devices, and more particularly, to semiconductor devices including a word line structure.

A semiconductor device is attracting attention as an important component in the electronics industry due to characteristics thereof such as miniaturization, multi-functionality, and/or low manufacturing cost. The semiconductor device may be classified into a semiconductor memory device that stores a logic data, a semiconductor logic device that calculates and processes the logic data, and a hybrid semiconductor device that includes a memory component and a logic component.

Recently, with a higher speed and lower power consumption of an electronic apparatus, a higher operation speed, a lower operation voltage and/or the like are/is also desired for the semiconductor device built therein. In order to satisfy such needs, a more highly-integrated semiconductor device is needed. However, when the semiconductor device becomes more highly-integrated, electrical characteristics and/or production yield of the semiconductor device may be reduced. Accordingly, various research for improving the electrical characteristics and/or the production yield of the semiconductor device is being carried out.

### SUMMARY

Some example embodiment of the present disclosure provide semiconductor devices with improved electrical characteristics and/or integration.

According to an example embodiment of the inventive concepts, a semiconductor device includes a bit line, a data storage structure spaced apart from the bit line, a word line structure between the bit line and the data storage structure, a channel pattern electrically connecting the bit line and the data storage structure, and a gate insulating layer including an interposed portion between the word line structure and the channel pattern, wherein the word line structure includes a gate pattern, and a first insulating pattern between the gate pattern and the interposed portion, the gate pattern includes a body portion spaced apart from the bit line in a first direction with the first insulating pattern therebetween, and a protrusion spaced apart from the interposed portion in a second direction with the first insulating pattern therebetween, the second direction crossing the first direction, and a distance in the first direction between the body portion and the bit line is greater than a distance in the first direction between the protrusion and the bit line. The data storage structure may be spaced apart from the bit line in the first direction. The word line structure may be between the bit line and the data storage structure in the first direction. The interposed portion may be between the word line structure and the first channel pattern in the second direction.

According to an example embodiment of the inventive concepts, a semiconductor device includes a bit line, a data storage structure spaced apart from the bit line, a word line structure between the bit line and the data storage structure, a first channel pattern electrically connecting the bit line and the data storage structure, and a gate insulating layer including an interposed portion between the word line structure and the first channel pattern, wherein the word line structure includes a gate pattern, an insulating pattern between the gate pattern and the bit line, and a work-function pattern between the gate pattern and the data storage structure, and the gate pattern includes a body portion between the insulating pattern and the work-function pattern, a first protrusion spaced apart from the interposed portion with a first part of the work-function pattern therebetween, and a second protrusion spaced apart from the interposed portion with the insulating pattern therebetween.

According to an embodiment of the inventive concepts, a semiconductor device includes a bit line, a data storage structure spaced apart from the bit line, a word line structure between the bit line and the data storage structure, a channel pattern electrically connecting the bit line and the data storage structure, and a gate insulating layer including an interposed portion between the word line structure and the channel pattern, wherein the word line structure includes a gate pattern, and a first insulating pattern, a second insulating pattern and a third insulating pattern between the gate pattern and the bit line, the channel pattern, the interposed portion and the first insulating pattern are between the second insulating pattern and the third insulating pattern, and the gate pattern includes a body portion spaced apart from the bit line in a first direction with the first to third insulating patterns therebetween, and a protrusion between the second and third insulating patterns.

According to an embodiment of the inventive concepts, a method of manufacturing a semiconductor device includes forming a plurality of sacrificial layers and a plurality of preliminary channel layers on a substrate to alternate each other in a vertical direction, forming a plurality of separation patterns extending in a first horizontal direction, each of the separation patterns penetrating the sacrificial layers and the preliminary channel layers in the vertical direction, the separation patterns being apart from each other in a second horizontal direction crossing the first horizontal direction, forming a plurality of trenches extending in the second horizontal direction, each of the trenches penetrating the sacrificial layers, the preliminary channel layers, and the separation patterns in the vertical direction, the trenches being apart from each other in the first direction, the trenches including a first trench and a pair of second trenches, the first trenches being between the pair of second trenches in the first horizontal direction, selectively removing the sacrificial layers and the separation patterns through the trenches, forming a preliminary interposed pattern layer in the first trench, sequentially forming a preliminary gate insulating layer, a preliminary filling pattern and a preliminary interlayered pattern in each of the second trenches, the preliminary filling pattern including a material having etching selectivity to the preliminary gate insulating layer and the preliminary interlayered pattern, selectively etching the preliminary interlayered pattern to form interlayered patterns, etching the preliminary filling pattern to form a plurality of filling patterns such that a plurality of cavities are defined by the preliminary gate insulating layer, the filing patterns, and the interlayered patterns in the vertical direction, conformally forming a preliminary work-function pattern on the interlayered patterns, the filling patterns and the preliminary gate insulating layer, performing a first etch-back process to divide a preliminary work-function pattern into a plurality of work-function patterns spaced apart in the vertical direction, forming a first preliminary gate layer on the work-function patterns, the interlayered patterns and the preliminary gate insulating layer to fill the cavities, performing a second etch-back process to selectively etch a first preliminary gate layer to form a plurality of first preliminary gate patterns such that a portion of each of the interlayered patterns is exposed between an adjacent pair of the first preliminary gate patterns, forming a plurality of selective deposition patterns selectively on the first preliminary gate patterns, respectively, forming a plurality of first preliminary insulating patterns on the preliminary gate insulating layer, forming a plurality of second preliminary insulating patterns on the interlayered pattern, the first preliminary insulating patterns and the second preliminary insulating patterns being spaced apart from each other and being alternate in the vertical direction, removing the selective deposition patterns, forming a second preliminary gate layer on the first and second preliminary insulating patterns and the first preliminary gate patterns, and etching the second preliminary gate layer, the first preliminary insulating patterns, the second preliminary insulating patterns, and the preliminary gate insulating layer to form a plurality of second preliminary gate patterns, a plurality of insulating patterns, and a plurality of gate insulating layers, respectively, such that each of the first preliminary gate patterns and a corresponding one of the second preliminary gate patterns forming a gate pattern.

At least some of the above and other features of the disclosure are set out in the claims.

### BRIEF DESCRIPTION OF THE FIGURES

The accompanying drawings are included to provide a further understanding of the inventive concepts, and are incorporated in and constitute a part of this specification. The drawings illustrate some example embodiments of the inventive concepts and, together with the description, serve to explain principles of the inventive concepts. In the drawings:
FIG. 1A is a schematic circuit diagram illustrating a semiconductor device according to an example embodiment;
FIGS. 1B, 1C and 1D are schematic perspective views of a semiconductor device according to an example embodiment;
FIG. 2A is a plan view of a semiconductor device according to an example embodiment;
FIG. 2B is a cross-sectional view taken along line A-A' of FIG. 2A;
FIG. 2C is a cross-sectional view taken along line B-B' of FIG. 2A;
FIG. 2D is a cross-sectional view taken along line C-C' of FIG. 2A;
FIG. 2E is a cross-sectional view taken along line D-D' of FIG. 2A;
FIG. 2F is an enlarged view of region Q1 of FIG. 2B;
FIG. 2G is an enlarged view of region Q5 of FIG. 2F;
FIG. 2H is an enlarged view of region Q2 of FIG. 2C;
FIG. 2I is an enlarged view of region Q3 of FIG. 2D;
FIG. 2J is an enlarged view of region Q4 of FIG. 2E; and
FIGS. 3A, 3B, 3C, 4A, 4B, 4C, 5A, 5B, 5C, 6A, 6B, 6C, 7A, 7B, 8A, 8B, 8C, 9A, 9B, 9C, 10, 11, 12A, 12B, 13, 14A, 14B and 15 are diagrams for describing a method for manufacturing a semiconductor device according to FIGS. 2A to 2I, according to an example embodiment.

### DETAILED DESCRIPTION

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "one of," "one or more of," "any one of," and "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

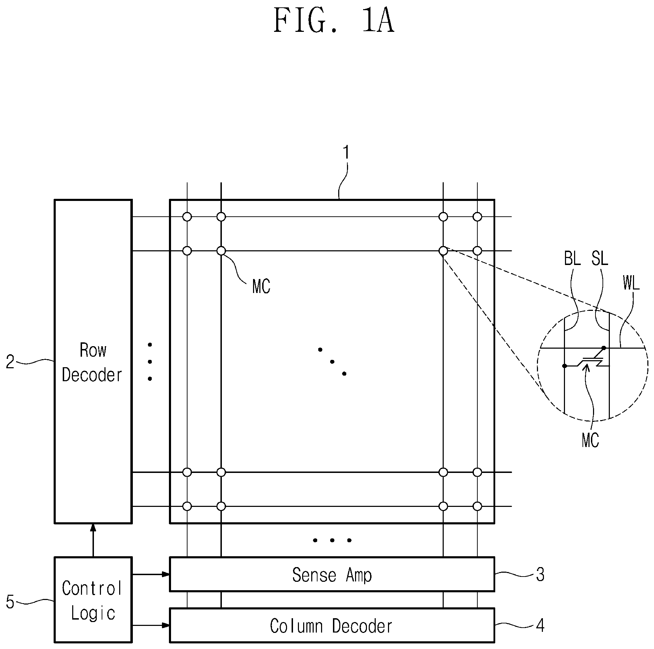

FIG. 1A is a schematic circuit diagram illustrating a semiconductor device according to an example embodiment.

Referring to FIG. 1A, the semiconductor device may include a memory cell array 1, a row decoder 2, a sense amplifier 3, a column decoder 4 and a control logic 5.

The memory cell array 1 may include word lines WL, bit lines BL, source lines SL and memory cells MC. The memory cells MC may be three-dimensionally arranged, and may be connected to one word line WL, one bit line BL, and one source line SL. According to some example embodiments, each of the memory cells MC may be composed of one transistor including a memory layer (or data storage layer).

The row decoder 2 may decode an address input from the outside, and may select any one among the word lines WL of the memory cell array 1. The address decoded by the row decoder 2 may be provided to a row driver (not shown), and the row driver may provide a selected word line WL and an unselected word line WL with desired (or alternatively, predetermined) voltages in response to a control of control circuits, respectively.

The sense amplifier 3 may sense, amplify and output a voltage difference between a bit line BL selected according to an address decoded by the column decoder 4 and a reference bit line.

The column decoder 4 may provide a data transfer path between the sense amplifier 3 and an external device (e.g., a memory controller). The column decoder 4 may select any one among the bit lines BL by decoding an address input from the outside.

The control logic 5 may generate control signals that control operations of writing a data to the memory cell array 1 or reading the data from the memory cell array 1.

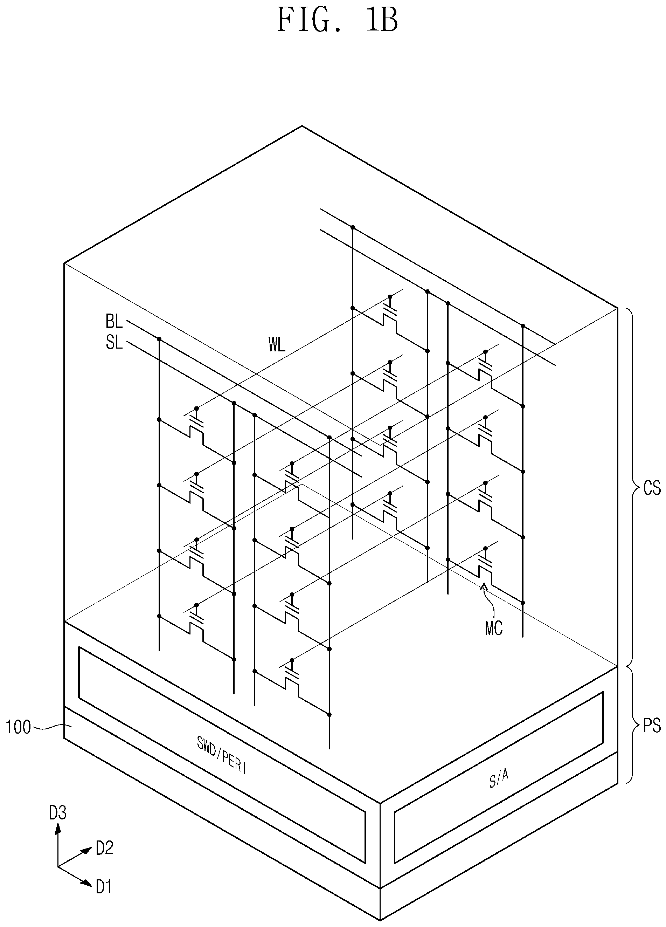

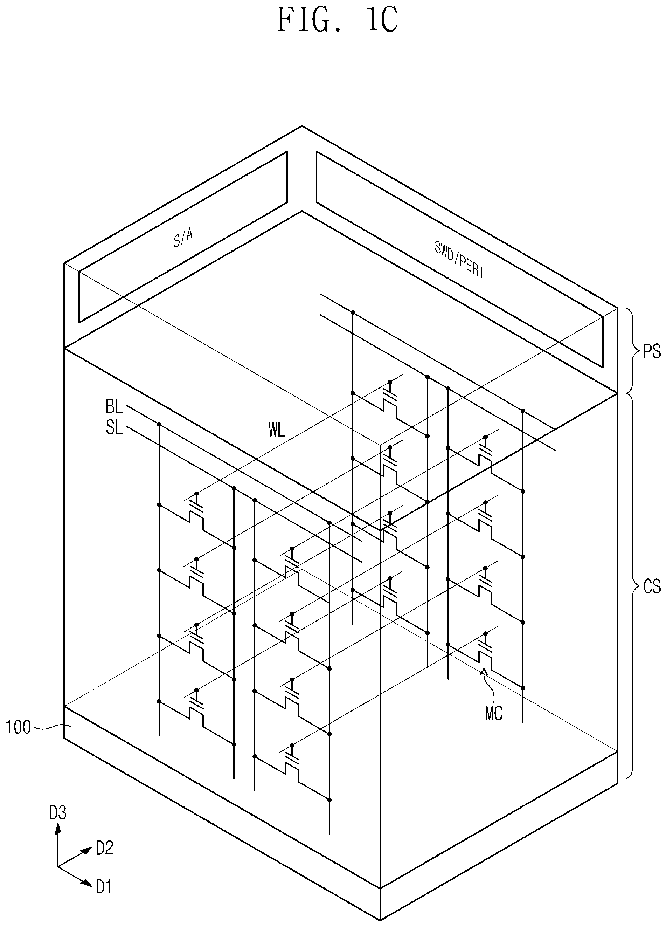

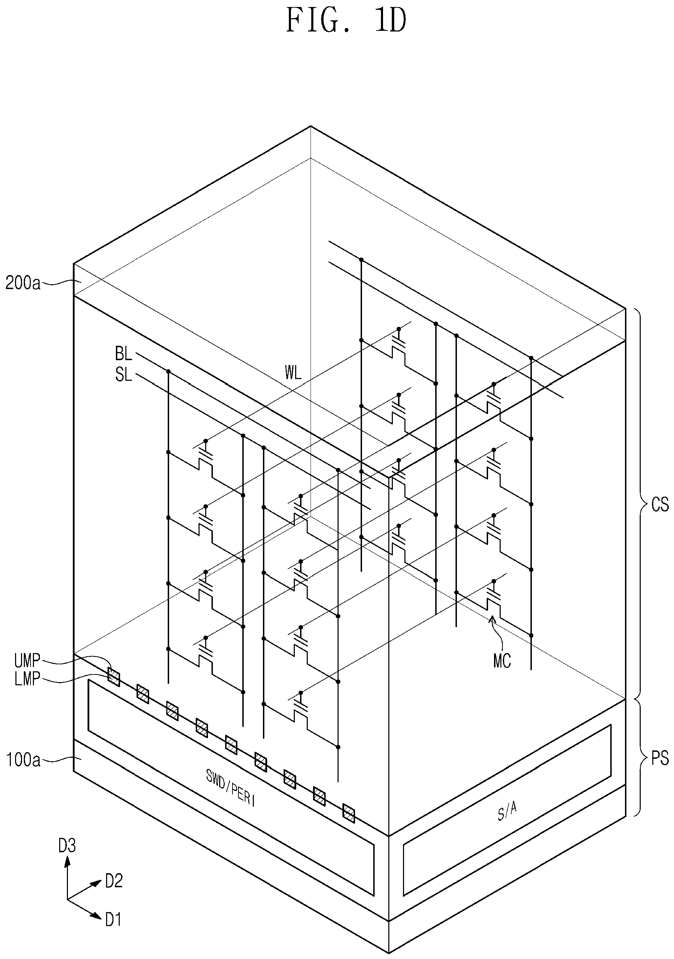

FIGS. 1B, 1C and 1D are schematic perspective views of the semiconductor device according to an example embodiment.

Referring to FIG. 1B, the semiconductor device may include a substrate 100, a peripheral circuit structure PS on the substrate 100 and a cell array structure CS on the peripheral circuit structure PS.

The peripheral circuit structure PS may include core and peripheral circuits formed on the substrate 100. The core and peripheral circuits may include the row and column decoders 2 and 4 (see FIG. 1A), the sense amplifier 3 (see FIG. 1A) and the control logic 5 (see FIG. 1A) described with reference to FIG. 1A.

The substrate 100 may have a shape of a plate expanding along a plane defined by a first direction D1 and a second direction D2. The first direction D1 and the second direction D2 may cross each other. For example, the first direction D1 and the second direction D2 may be horizontal directions perpendicular to each other. The peripheral circuit structure PS and the cell array structure CS may be sequentially stacked on the substrate 100 in a third direction D3. The third direction D3 may cross the first direction D1 and the second direction D2. For example, the third direction D3 may be a vertical direction perpendicular to the first direction D1 and the second direction D2. While the first, second and third directions D1, D2, D3, respectively, are referred to as such, one of ordinary skill in the art will appreciate such designations may be modified. For example, the second direction D2 may be referred to a first direction, the third direction D3 as a first direction, and the first direction D1 as a third direction.

The cell array structure CS may include the bit lines BL, the source lines SL, the word lines WL and the memory cells MC therebetween. Each of the memory cells MC may be connected to one word line WL, one bit line BL and one source line SL.

Referring to FIG. 1C, the semiconductor device may include the cell array structure CS on the substrate 100, and the peripheral circuit structure PS on the cell array structure CS. The cell array structure CS may be disposed between the substrate 100 and the peripheral circuit structure PS. The peripheral circuit structure PS may include core and peripheral circuits.

Referring to FIG. 1D, the semiconductor device may have a chip-to-chip (C2C) structure. The peripheral circuit structure PS may include a first substrate 100a. Lower metal pads LMP may be provided on an uppermost portion of the peripheral circuit structure PS. The lower metal pads LMP may be electrically connected to the core and peripheral circuits. The lower metal pads LMP may be bonded to upper metal pads UMP of the cell array structure CS.

The cell array structure CS may include a second substrate 200a, and the upper metal pads UMP may be provided on a lowermost portion of the cell array structure CS. The upper metal pads UMP may be electrically connected to the bit lines BL, the source lines SL and the word lines WL. The upper metal pads UMP may be electrically connected to the memory cells MC.

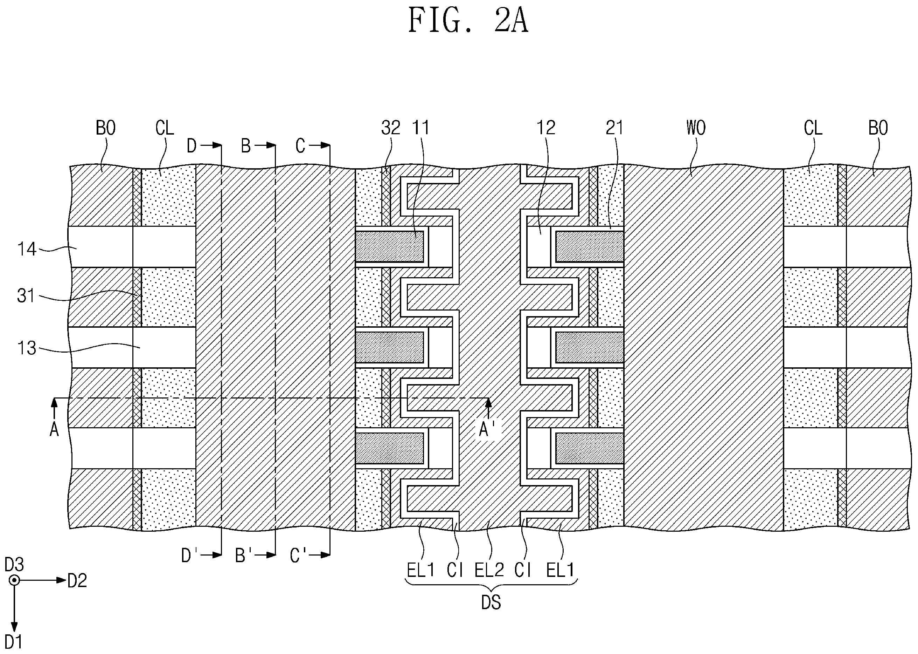

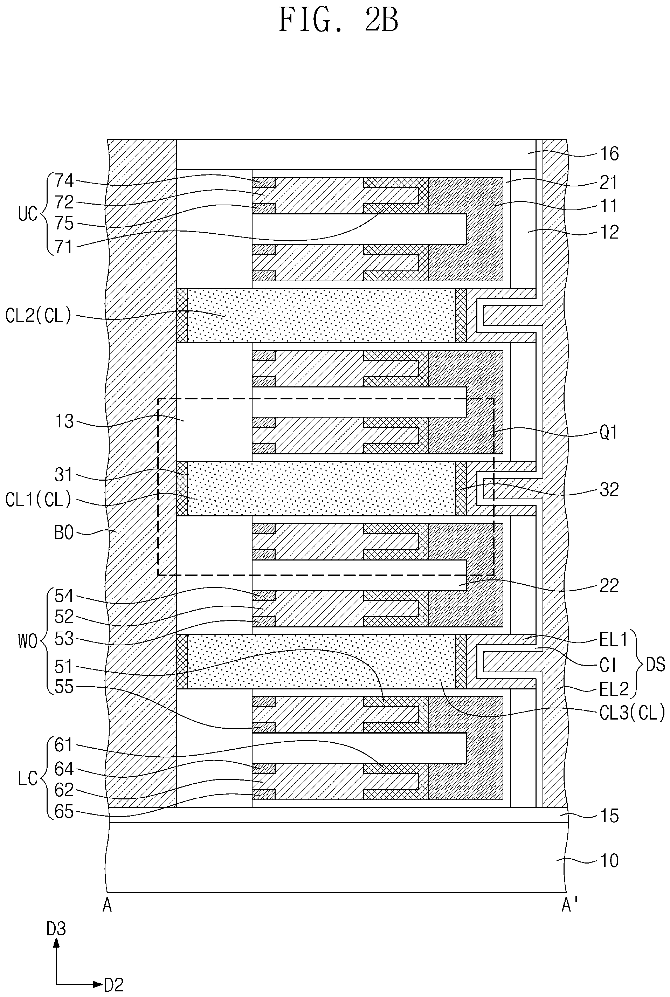

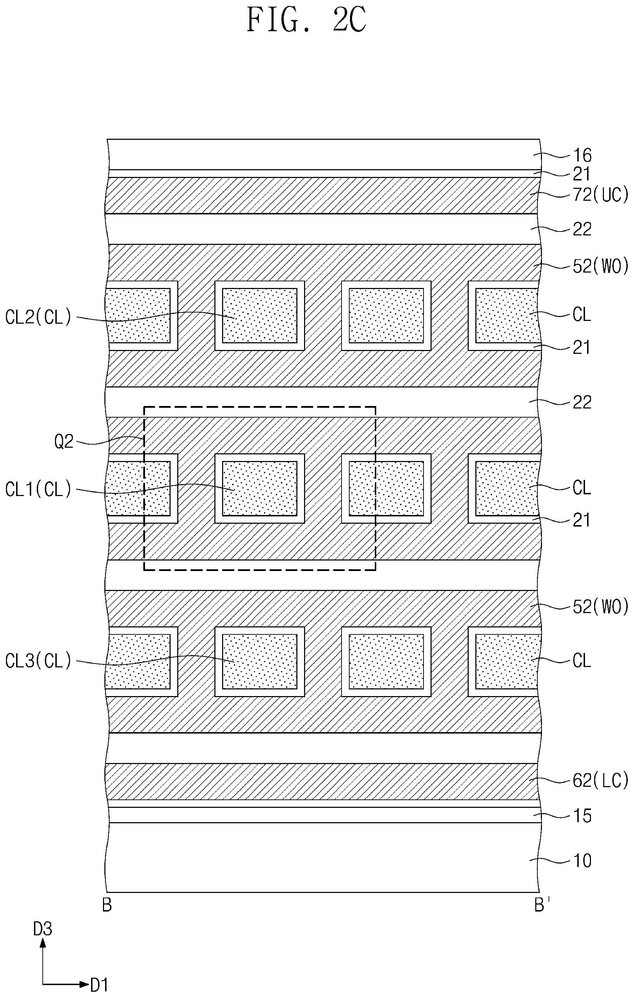

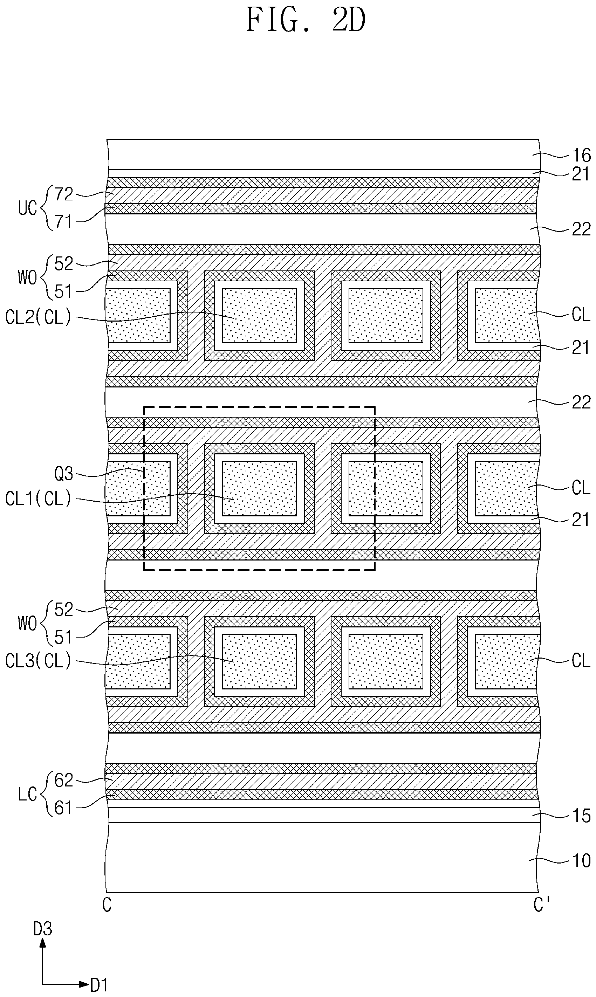

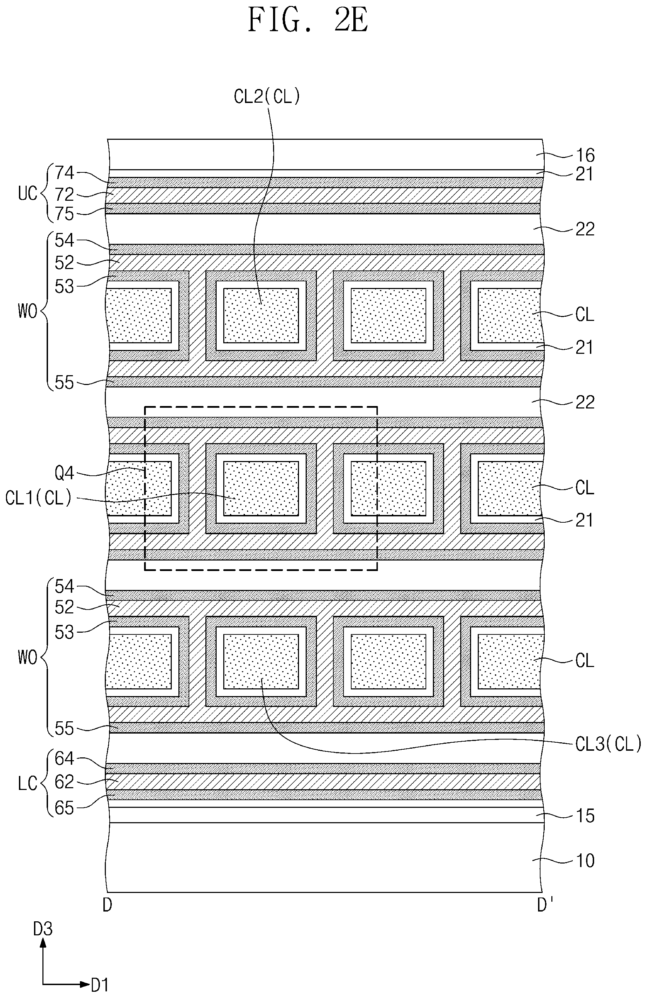

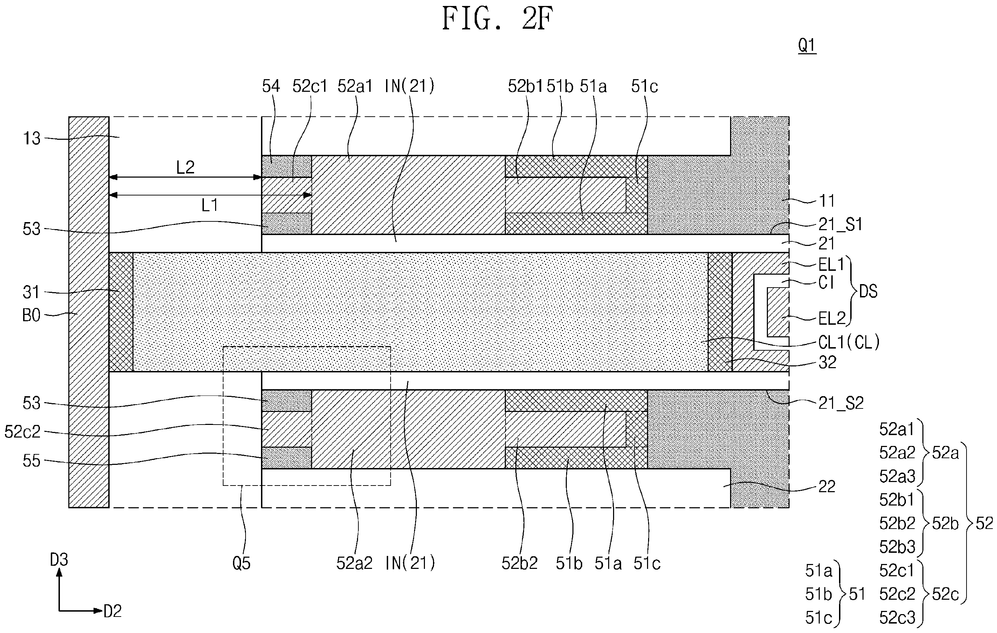

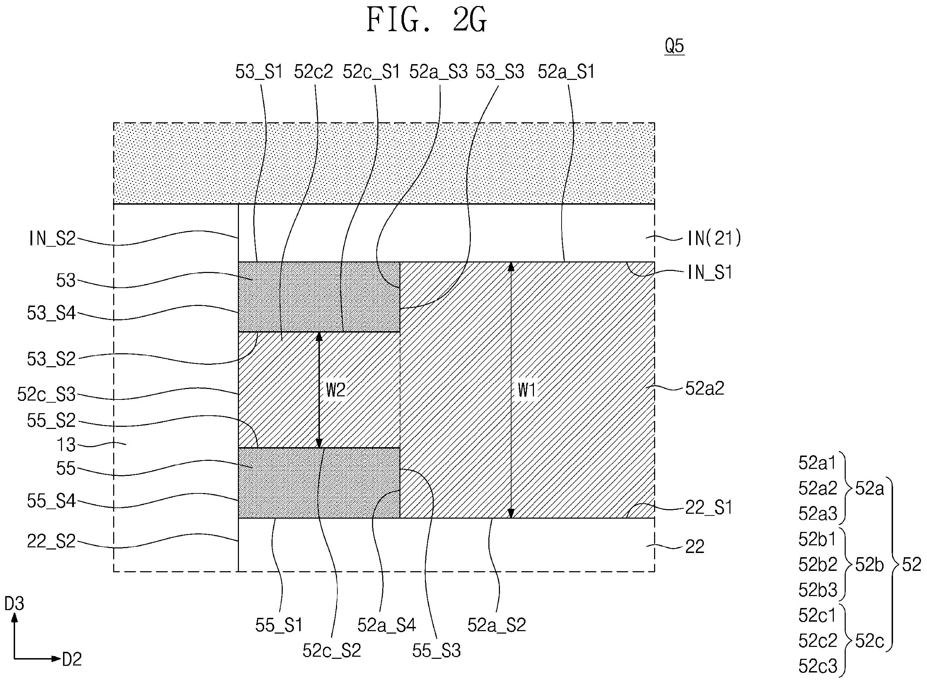

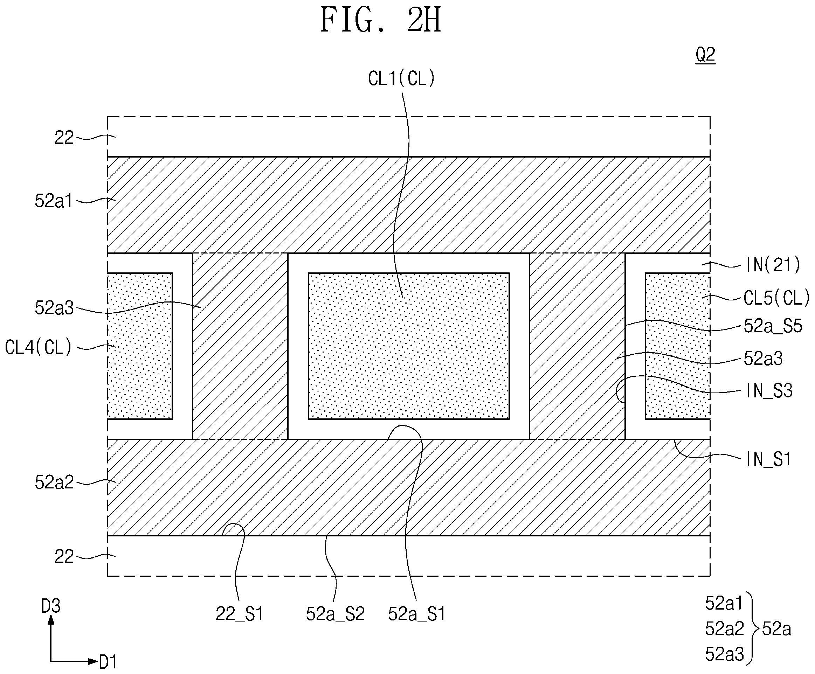

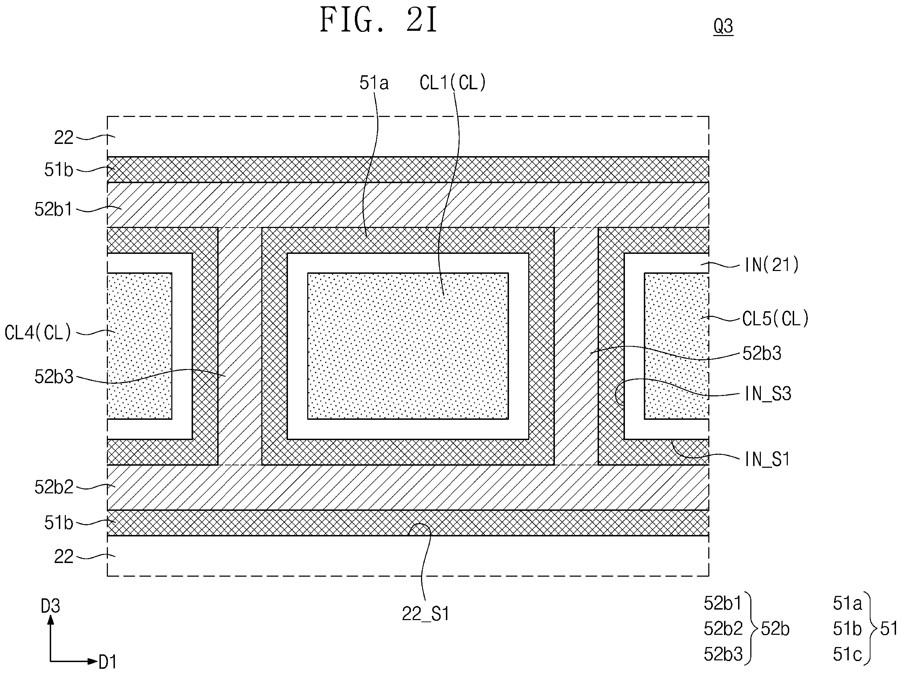

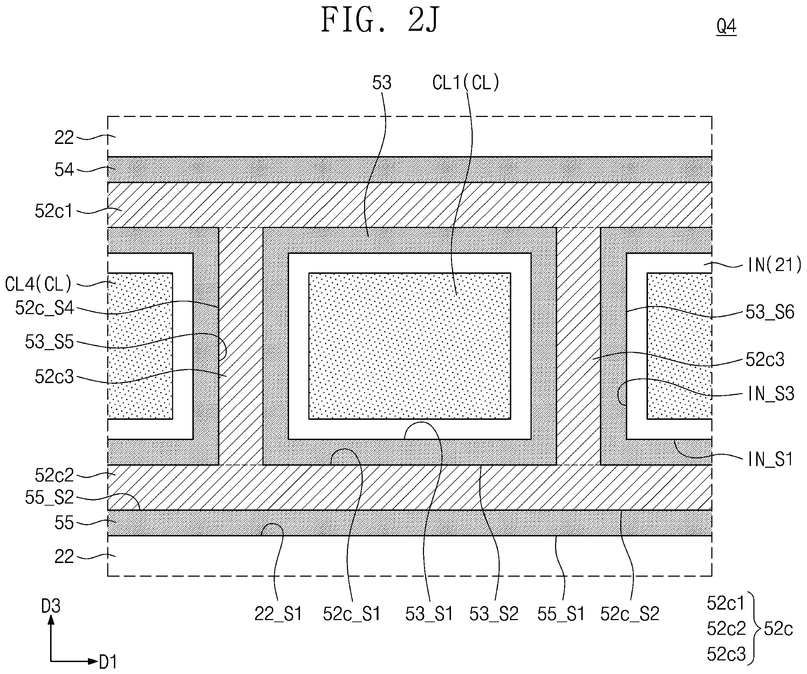

FIG. 2A is a plan view of a semiconductor device according to an example embodiment. FIG. 2B is a cross-sectional view taken along line A-A' of FIG. 2A. FIG. 2C is a cross-sectional view taken along line B-B' of FIG. 2A. FIG. 2D is a cross-sectional view taken along line C-C' of FIG. 2A. FIG. 2E is a cross-sectional view taken along line D-D' of FIG. 2A. FIG. 2F is an enlarged view of region Q1 of FIG. 2B. FIG. 2G is an enlarged view of region Q5 of FIG. 2F. FIG. 2H is an enlarged view of region Q2 of FIG. 2C. FIG. 2I is an enlarged view of region Q3 of FIG. 2D. FIG. 2J is an enlarged view of region Q4 of FIG. 2E.

Referring to FIGS. 2A, 2B, 2C, 2D and 2E, the semiconductor device may include a substrate 10. The substrate 10 may have a shape of a plate expanding along a plane defined by the first direction D1 and the second direction D2.

The substrate 10 may be a semiconductor substrate. For example, the substrate 10 may include silicon, germanium, or silicon-germanium. According to some example embodiments, the substrate 10 may be an insulating substrate or a semiconductor-on-insulator (SOI) substrate.

A lower insulating layer 15 may be provided on the substrate 10. The lower insulating layer 15 may include an insulating material. According to some example embodiments, the lower insulating layer 15 may include a plurality of insulating layers. According to some example embodiments, peripheral transistors may be disposed between the substrate 10 and the lower insulating layer 15.

A cell array structure may be provided on the lower insulating layer 15. The cell array structure may include bit lines BO, channel patterns CL, first conductive patterns 31, second conductive patterns 32, word line structures WO, upper conductive structures UC, lower conductive structures LC, a data storage structure DS, gate insulating layers 21, interlayered patterns 22, filling patterns 11, first interposed patterns 12, second interposed patterns 13, third interposed patterns 14 and an upper insulating layer 16.

The bit lines BO may be provided on the lower insulating layer 15. The bit line BO may extend in the third direction D3. The third direction D3 may cross the first direction D1 and the second direction D2. For example, the third direction D3 may be a vertical direction perpendicular to the first direction D1 and the second direction D2. While the first, second and third directions D1, D2, D3, respectively, are referred to as such, one of ordinary skill in the art will appreciate such designations may be modified. For example, the second direction D2 may be referred to a first direction, the third direction D3 as a first direction, and the first direction D1 as a third direction.

One bit line BO may be electrically connected to the channel patterns CL overlapping or overlaying each other in the third direction D3. The channel patterns CL may be connected to only one side of the bit line BO.

The bit lines BO may be arranged spaced apart from each other in the first direction D1. The bit line BO may be spaced apart from the data storage structure DS in the second direction D2. The bit line BO may include a conductive material. For example, the bit line BO may include metal.

The first conductive patterns 31 may be provided between the bit line BO and the channel patterns CL. The channel pattern CL may be electrically connected to the bit line BO through the first conductive pattern 31. The first conductive pattern 31 may include a conductive material. For example, the first conductive pattern 31 may include metal silicide.

According to some example embodiments, the bit line BO may include polysilicon. In this case, the first conductive pattern 31 may be omitted, and the channel pattern CL may be in contact with (e.g., in physical contact with) the bit line BO.

The third interposed pattern 14 may be provided between the bit lines BO. The third interposed patterns 14 may be arranged spaced apart from each other in the first direction D1. The third interposed patterns 14 and the bit lines BO may be alternately arranged along the first direction D1. The third interposed pattern 14 may include an insulating material. According to some example embodiments, the third interposed pattern 14 may be multiple layers including a plurality of insulating layers.

The data storage structure DS may be provided on the lower insulating layer 15. The data storage structure DS may be a capacitor including first electrodes EL1 and a second electrode EL2 and a capacitor insulating layer CI. The first electrodes EL1 may be spaced apart from the second electrode EL2. The capacitor insulating layer CI may be provided between the first electrode EL1 and the second electrode EL2. The first and second electrodes EL1 and EL2 may include a conductive material. The capacitor insulating layer CI may include an insulating material. The channel patterns CL may be connected to both sides of the data storage structure DS, respectively. The data storage structure DS may be disposed between the bit lines BO spaced apart from each other in the second direction D2.

According to some example embodiments, the data storage structures DS spaced apart from each other in the second direction D2 may be provided, and the bit line BO may be disposed between the data storage structures DS.

According to some example embodiments, the data storage structure DS may be a variable resistance pattern capable of being switched between two resistance states by an electrical pulse. In this case, the data storage structure DS may include a phase-change material changing a crystalline state according to an amount of current, a perovskite compound, transition metal oxide, a magnetic material, a ferromagnetic material, or an antiferromagnetic material.

The channel patterns CL may include channel patterns CL overlapping or overlaying each other in the third direction D3. The channel patterns CL may include channel patterns CL arranged in the first direction D1. The channel pattern CL may extend in the second direction D2. The channel pattern CL may be disposed between the data storage structure DS and the bit line BO. The channel patterns CL may be electrically connected to the data storage structure DS and the bit line BO. The channel pattern CL may be in contact with (e.g., in physical contact with) the first conductive pattern 31 and the second conductive pattern 32. The data storage structure DS and the bit line BO may be electrically connected to each other by a plurality of channel patterns CL overlapping or overlaying each other in the third direction D3.

The channel pattern CL may include at least one of single-crystalline semiconductor, polycrystalline semiconductor, oxide semiconductor or a two-dimensional material. For example, the single-crystalline semiconductor may be single-crystalline silicon. For example, the polycrystalline semiconductor may be polysilicon. For example, the oxide semiconductor may be indium-gallium-zinc oxide (IGZO). For example, the two-dimensional material may be MoS₂, WS₂, MoSe₂ or WSe₂.

The second conductive pattern 32 may be provided between the first electrode EL1 and the channel pattern CL of the data storage structure DS. The channel pattern CL may be electrically connected to the first electrode EL1 of the data storage structure DS through the second conductive pattern 32. The second conductive pattern 32 may include a conductive material. For example, the second conductive pattern 32 may include metal silicide (e.g., MoSi, or TiSi).

The word line structure WO, the upper conductive structure UC and the lower conductive structure LC may extend in the first direction D1. The word line structures WO may be disposed between the upper conductive structure UC and the lower conductive structure LC. The word line structures WO, the upper conductive structure UC and the lower conductive structure LC may overlap or overlay each other in the third direction D3. At least a portion of the word line structures WO may overlap or overlay at least a portion the lower conductive structure LC in the third direction D3. At least a portion of the word line structures WO may be overlapped or overlaid by at least a portion of the upper conductive structure UC in the third direction D3. At least a portion of the upper conductive structure UC may overlap or overlay at least a portion of the word line structure WO in the third direction D3. The word line structure WO, the upper conductive structure UC and the lower conductive structure LC may be provided between the bit line BO and the data storage structure DS, e.g., in the second direction D2. The word line structure WO, the upper conductive structure UC and the lower conductive structure LC may be spaced apart from the bit lines BO in the second direction D2. The word line structure WO, the upper conductive structure UC and the lower conductive structure LC may be spaced apart from the data storage structure DS in the second direction D2. The channel pattern CL may penetrate the word line structure WO in the second direction D2. On cross-sectional views according to FIGS. 2C, 2D and 2E, the word line structure WO may surround the channel patterns CL arranged in the first direction D1.

The word line structure WO may include a work-function pattern 51, a gate pattern 52, first insulating patterns 53, a second insulating pattern 54 and a third insulating pattern 55. The work-function pattern 51 may be disposed between the gate pattern 52 and the data storage structure DS. The first to third insulating patterns 53, 54 and 55 may be disposed between the gate pattern 52 and the bit line BO. The gate pattern 52 may be disposed between the work-function pattern 51 and the first to third insulating patterns 53, 54 and 55.

On a cross-sectional view according to FIG. 2E, the first insulating pattern 53 may surround the channel pattern CL, e.g., in the first and/or third directions D1, D3. On a cross-sectional view according to FIG. 2E, the gate pattern 52 may surround the first insulating patterns 53 arranged in the first direction D1. On cross-sectional views according to FIGS. 2C, 2D and 2E, the gate pattern 52 may surround the channel patterns CL arranged in the first direction D1. On a cross-sectional view according to FIG. 2D, the work-function pattern 51 may surround the channel pattern Cl, e.g., in the first and/or third direction D1, D3. Interposed portions IN to be described later, the channel patterns CL and the first insulating patterns 53 may be disposed between the second insulating pattern 54 and the third insulating pattern 55 included in one word line structure WO, e.g., in the third direction D3.

The work-function pattern 51 may have a smaller effective work-function than the gate pattern 52. For example, the work-function pattern 51 may have an effective work-function of about 4.2 eV or less, and the gate pattern 52 may have an effective work-function greater than about 4.6 eV. For example, the work-function pattern 51 may include polysilicon doped with a P type impurity or TiN doped with La₂O₃. For example, the gate pattern 52 may be a TiN layer, a W layer, a Mo layer or a Ru layer. For example, the gate pattern 52 may be multiple layers including the TiN layer and the W layer, or multiple layers including the TiN layer and the Mo layer.

The first to third insulating patterns 53, 54 and 55 may include a high-dielectric material. The first to third insulating patterns 53, 54 and 55 may include a material (e.g., La₂O₃ orY₂O₃) having a smaller oxygen density per unit volume than SiO₂.

For example, a thickness of each of the work-function pattern 51 and the first to third insulating patterns 53, 54 and 55 may be about 2 nm to about 3 nm.

The upper conductive structure UC may include an upper work-function pattern 71, an upper gate pattern 72, a first upper insulating pattern 74 and a second upper insulating pattern 75. The lower conductive structure LC may include a lower work-function pattern 61, a lower gate pattern 62, a first lower insulating pattern 64 and a second lower insulating pattern 65.

The upper work-function pattern 71 and the lower work-function pattern 61 may include the same material as the work-function pattern 51. The upper gate pattern 72 and the lower gate pattern 62 may include the same material as the gate pattern 52. The first and second upper insulating patterns 74 and 75 and the first and second lower insulating patterns 64 and 65 may include the same material as the first to third insulating patterns 53, 54 and 55.

The gate insulating layer 21 may be in contact with (e.g., in physical contact with) the word line structure WO and the channel pattern CL. The word line structure WO and the channel pattern CL may be spaced apart from each other by the gate insulating layer 21. The gate insulating layer 21 may include an insulating material. For example, the gate insulating layer 21 may include oxide. According to some example embodiments, the gate insulating layer 21 may be multiple layers including a plurality of insulating layers.

The interlayered pattern 22 may be provided between the word line structures WO, between the word line structure WO and the upper conductive structure UC, or between the word line structure WO and the lower conductive structure LC. The interlayered pattern 22 may be disposed between the channel patterns CL. The interlayered pattern 22 may include an insulating material. For example, the interlayered pattern 22 may include oxide. According to some example embodiments, the interlayered pattern 22 may be multiple layers including a plurality of insulating layers.

The filling pattern 11 may be disposed between the data storage structure DS and the word line structure WO. The filling pattern 11 may be in contact with (e.g., in physical contact with) the work-function pattern 51, the gate insulating layer 21 and the interlayered pattern 22. The filling pattern 11 may include an insulating material. For example, the filling pattern 11 may include nitride. According to some example embodiments, the filling pattern 11 may be multiple layers including a plurality of insulating layers.

The first interposed pattern 12 may be disposed between the data storage structure DS and the filling pattern 11. The first interposed pattern 12 may be disposed between the gate insulating layer 21 and the data storage structure DS. The first interposed pattern 12 may be in contact with (e.g., in physical contact with) the gate insulating layer 21 and the data storage structure DS. The first interposed pattern 12 may include an insulating material. For example, the first interposed pattern 12 may include oxide. According to some example embodiments, the first interposed pattern 12 may be multiple layers including a plurality of insulating layers.

The second interposed pattern 13 may be disposed between the word line structure WO and the bit line BO. The second interposed pattern 13 may be in contact with (e.g., in physical contact with) the word line structure WO and the bit line BO. The second interposed pattern 13 may include an insulating material. For example, the second interposed pattern 13 may include oxide. According to some example embodiments, the second interposed pattern 13 may be multiple layers including a plurality of insulating layers.

The upper insulating layer 16 may include an insulating material. According to some example embodiments, the upper insulating layer 16 may include a plurality of insulating layers.

The channel pattern CL may include a first channel pattern CL1, a second channel pattern CL2 and a third channel pattern CL3 overlapping or overlaying each other in the third direction D3. The first channel pattern CL1 and the second channel pattern CL2 may be adjacent to each other in the third direction D3. The first channel pattern CL1 and the third channel pattern CL3 may be adjacent to each other in the third direction D3. The first channel pattern CL1 may be disposed between the second and third channel patterns CL2 and CL3. While the first through third channel patterns CL1 through CL3 are referred to as such, this nomenclature may be altered. For example, a third channel pattern may be referred to as CL2 and a second channel pattern as CL3. Further, while the third channel pattern CL3 is illustrated and described as overlapping or overlaying the first channel pattern CL1 and the second channel pattern CL2, the second channel pattern CL2 may alternatively overlay or overlap the first channel pattern CL1. In this arrangement, the third channel pattern CL3 may overlay or overlap the second channel pattern CL2.

Referring to FIGS. 2F, 2G, 2H, 2I and 2J, the gate insulating layer 21 may include the interposed portion IN between the word line structure WO and the channel pattern CL. The gate pattern 52 may include a body portion 52a, a first protrusion portion 52b and a second protrusion portion 52c. While the first protrusion portion 52b and the second protrusion portion 52c are referred to as such, this nomenclature may be reversed. For example, the first protrusion portion 52b may be referred to as a second protrusion or second protrusion portion, and the second protrusion portion 52c may be referred to as a first protrusion or first protrusion portion. The body portion 52a may be disposed between the first protrusion portion 52b and the second protrusion portion 52c. The body portion 52a may be spaced apart from the bit line BO in the second direction D2 with the second protrusion portion 52c therebetween. The body portion 52a may be spaced apart from the data storage structure DS in the second direction D2 with the first protrusion portion 52b therebetween. The body portion 52a may be disposed between the work-function pattern 51 and the first to third insulating patterns 53, 54 and 55. The body portion 52a may be spaced apart from the bit line BO in the second direction D2 with the first to third insulating patterns 53, 54 and 55 therebetween. The body portion 52a may be spaced apart from the data storage structure DS in the second direction D2 with the work-function pattern 51 therebetween. The channel pattern CL, the interposed portion IN, the first insulating pattern 53 and the second protrusion portion 52c may be disposed between the second and third insulating patterns 54 and 55.

The work-function pattern 51 may include a first part 51a, a second part 51b and a third part 51c. The first part 51a and the second part 51b of the work-function pattern 51 may be spaced apart from each other in the third direction D3. The third part 51c of the work-function pattern 51 may connect the first part 51a and the second part 51b of the work-function pattern 51. The first part 51a may generally extend in the second direction D2. The second part 51b may generally extend in the second direction D2. The third part may generally extend in the third direction D3.

The first insulating pattern 53 may be disposed between the gate pattern 52 and the interposed portion IN. The first part 51a of the work-function pattern 51 may be disposed between the gate pattern 52 and the interposed portion IN. The first protrusion portion 52b may be spaced apart from the interposed portion IN of the gate insulating layer 21 in the third direction D3 with the first part 51a of the work-function pattern 51 therebetween. The second protrusion portion 52c may be spaced apart from the interposed portion IN of the gate insulating layer 21 in the third direction D3 with the first insulating pattern 53 therebetween. The first and second parts 51a and 51b of the work-function pattern 51 may be spaced apart from each other in the third direction D3 with the first protrusion portion 52b therebetween. The first and second insulating patterns 53 and 54 may be spaced apart from each other in the third direction D3 with the second protrusion portion 52c therebetween. The first and third insulating patterns 53 and 55 may be spaced apart from each other in the third direction D3 with the second protrusion portion 52c therebetween.

The body portion 52a may include a first line portion 52a1, a second line portion 52a2 and connection portions 52a3. The connection portions 52a3 of the body portion 52a may connect the first line portion 52a1 and the second line portion 52a2 of the body portion 52a. The first protrusion portion 52b may include a first line portion 52b1, a second line portion 52b2 and connection portions 52b3. The connection portions 52b3 of the first protrusion portion 52b may connect the first line portion 52b1 and the second line portion 52b2 of the first protrusion portion 52b. The second protrusion portion 52c may include a first line portion 52c1, a second line portion 52c2 and connection portions 52c3. The connection portions 52c3 of the second protrusion portion 52c may connect the first line portion 52c1 and the second line portion 52c2 of the second protrusion portion 52c.

The first line portion 52c1 of the second protrusion portion 52c may be disposed between the first and second insulating patterns 53 and 54. The second line portion 52c2 of the second protrusion portion 52c may be disposed between the first and third insulating patterns 53 and 55.

The first line portion 52b1 of the first protrusion portion 52b may be disposed between the first and second parts 51a and 51b of the work-function pattern 51. The second line portion 52b2 of the first protrusion portion 52b may be disposed between the first and second parts 51a and 51b of the work-function pattern 51.

The channel patterns CL may include a fourth channel pattern CL4 and a fifth channel pattern CL5 disposed at the same level as the first channel pattern CL1. The fourth channel pattern CL4 may be adjacent to the first channel pattern CL1 in the first direction D1. The fifth channel pattern CL5 may be adjacent to the first channel pattern CL1 in the first direction D1. The first channel pattern CL1 may be disposed between the fourth and fifth channel patterns CL4 and CL5.

The connection portion 52a3 of the body portion 52a, the connection portion 52b3 of the first protrusion portion 52b and the connection portion 52c3 of the second protrusion portion 52c may be disposed between the first and fourth channel patterns CL1 and CL4. The connection portion 52a3 of the body portion 52a, the connection portion 52b3 of the first protrusion portion 52b and the connection portion 52c3 of the second protrusion portion 52c may be disposed between the first and fifth channel patterns CL1 and CL5.

On a cross-sectional view according to FIG. 2H, the channel pattern CL and the interposed portion IN of the gate insulating layers 21 may be disposed between the first and second line portions 52a1 and 52a2 of the body portion 52a, and between the connection portions 52a3 of the body portion 52a.

On a cross-sectional view according to FIG. 2H, the channel pattern CL and the interposed portion IN may be surrounded by the body portion 52a.

On a cross-sectional view according to FIG. 2I, the first part 51a of the work-function pattern 51, the channel pattern CL and the interposed portion IN of the gate insulating layer 21 may be disposed between the first and second line portions 52b1 and 52b2 of the first protrusion portion 52b, and between the connection portions 52b3 of the first protrusion portion 52b.

On a cross-sectional view according to FIG. 2I, the first part 51a of the work-function pattern 51 may surround the channel pattern CL and the interposed portion IN, and the first protrusion portion 52b may surround the channel pattern CL, the interposed portion IN and the first part 51a of the work-function pattern 51.

On a cross-sectional view according to FIG. 2J, the first insulating pattern 53, the channel pattern CL and the interposed portion IN of the gate insulating layer 21 may be disposed between the first and second line portions 52c1 and 52c2 of the second protrusion portion 52c, and between the connection portions 52c3 of the second protrusion portion 52c.

On a cross-sectional view according to FIG. 2J, the first insulating pattern 53 may surround the channel pattern CL and the interposed portion IN, and the second protrusion portion 52c may surround the channel pattern CL, the interposed portion IN and the first insulating pattern 53.

The first line portion 52a1 of the body portion 52a, the first line portion 52b1 of the first protrusion portion 52b and the first line portion 52c1 of the second protrusion portion 52c may be disposed between the first channel pattern CL1 and the second channel pattern CL2 (see FIGS. 2B to 2E). The second line portion 52a2 of the body portion 52a, the second line portion 52b2 of the first protrusion portion 52b and the second line portion 52c2 of the second protrusion portion 52c may be disposed between the first channel pattern CL1 and the third channel pattern CL3 (see FIGS. 2B to 2E).

A width W1 in the third direction D3 of the line portion 52a1 or 52a2 of the body portion 52a may be greater than a width in the third direction D3 of the line portion 52b1 or 52b2 of the first protrusion portion 52b and a width W2 in the third direction D3 of the line portion 52c1 or 52c2 of the second protrusion portion 52c.

A width in the first direction D1 of the connection portion 52a3 of the body portion 52a may be greater than a width in the first direction D1 of the connection portion 52b3 of the first protrusion portion 52b and a width in the first direction D1 of the connection portion 52c3 of the second protrusion portion 52c.

A distance between the body portion 52a and the interposed portion IN may be smaller than a distance between the first protrusion portion 52b and the interposed portion IN. The distance may be smaller in the third direction D3. A distance between the body portion 52a and the interposed portion IN may be smaller than a distance between the second protrusion portion 52c and the interposed portion IN. The distance may be smaller in the third direction D3.

Referring to FIGS. 2F and 2G, the interposed portion IN may include a first surface IN _S1 and a second surface IN_S2. The first surface IN_S1 of the interposed portion IN may be parallel to the first direction D1 and the second direction D2. The second surface IN_S2 of the interposed portion IN may be parallel to the first direction D1 and the third direction D3.

The body portion 52a may include a first surface 52a_S1, a second surface 52a_S2, a third surface 52a_S3 and a fourth surface 52a_S4. The first surface 52a_S1 and the second surface 52a_S2 of the body portion 52a may be parallel to the first direction D1 and the second direction D2. The third surface 52a_S3 and the fourth surface 52a_S4 of the body portion 52a may be parallel to the first direction D1 and the third direction D3. The first to fourth surfaces 52a_S1, 52a_S2, 52a_S3 and 52a_S4 of the body portion 52a may be surfaces of the second line portion 52a2 of the body portion 52a.

The second protrusion portion 52c may include a first surface 52c_S1, a second surface 52c_S2 and a third surface 52c_S3. The first surface 52c_S1 and the second surface 52c_S2 of the second protrusion portion 52c may be parallel to the first direction D1 and the second direction D2. The third surface 52c_S3 of the second protrusion portion 52c may be parallel to the first direction D1 and the third direction D3. The first to third surfaces 52c_S1, 52c_S2 and 52c_S3 of the second protrusion portion 52c may be surfaces of the second line portion 52c2 of the second protrusion portion 52c.

The first insulating pattern 53 may include a first surface 53_S1, a second surface 53_S2, a third surface 53_S3 and a fourth surface 53_S4. The first surface 53_S1 and the second surface 53_S2 of the first insulating pattern 53 may be parallel to the first direction D1 and the second direction D2. The third surface 53_S3 and the fourth surface 53_S4 of the first insulating pattern 53 may be parallel to the first direction D1 and the third direction D3.

The third insulating pattern 55 may include a first surface 55_S1, a second surface 55_S2, a third surface 55_S3 and a fourth surface 55_S4. The first surface 55_S1 and the second surface 55_S2 of the third insulating pattern 55 may be parallel to the first direction D1 and the second direction D2. The third surface 55_S3 and the fourth surface 55_S4 of the third insulating pattern 55 may be parallel to the first direction D1 and the third direction D3.

The interlayered pattern 22 may include a first surface 22_S1 and a second surface 22_S2. The first surface 22_S1 of the interlayered pattern 22 may be parallel to the first direction D1 and the second direction D2. The second surface 22_S2 of the interlayered pattern 22 may be parallel to the first direction D1 and the third direction D3.

The first surface 53_S1 of the first insulating pattern 53, the first surface 52a_S1 of the body portion 52a and the first part 51a of the work-function pattern 51 may be in contact with (e.g., in physical contact with) the first surface IN_S1 of the interposed portion IN. The first surface 53_S1 of the first insulating pattern 53 and the first surface 52a_S1 of the body portion 52a may be coplanar with each other. The first surface 53_S1 of the first insulating pattern 53 and the first surface 52a_S1 of the body portion 52a may be connected to each other. The second surface IN_S2 of the interposed portion IN may be in contact with (e.g., in physical contact with) the second interposed pattern 13.

The first surface 22_S1 of the interlayered pattern 22 may be in contact with (e.g., in physical contact with) the second surface 52a_S2 of the body portion 52a, the first surface 55_S1 of the third insulating pattern 55 and the second part 51b of the work-function pattern 51. The second surface 52a_S2 of the body portion 52a and the first surface 55_S1 of the third insulating pattern 55 may be coplanar with each other. The second surface 52a_S2 of the body portion 52a and the first surface 55_S1 of the third insulating pattern 55 may be connected to each other. The second surface 22_S2 of the interlayered pattern 22 may be in contact with (e.g., in physical contact with) the second interposed pattern 13.

The third surface 52a_S3 of the body portion 52a may be in contact with (e.g., in physical contact with) the third surface 53_S3 of the first insulating pattern 53. The fourth surface 52a_S4 of the body portion 52a may be in contact with (e.g., in physical contact with) the third surface 55_S3 of the third insulating pattern 55.

The first surface 52c_S1 of the second protrusion portion 52c may be in contact with (e.g., in physical contact with) the second surface 53_S2 of the first insulating pattern 53. The second surface 52c_S2 of the second protrusion portion 52c may be in contact with (e.g., in physical contact with) the second surface 55_S2 of the third insulating pattern 55. The third surface 52c_S3 of the second protrusion portion 52c may be in contact with (e.g., in physical contact with) the second interposed pattern 13.

The fourth surface 53_S4 of the first insulating pattern 53 and the fourth surface 55_S4 of the third insulating pattern 55 may be in contact with (e.g., in physical contact with) the second interposed pattern 13. The fourth surface 53_S4 of the first insulating pattern 53, the fourth surface 55_S4 of the third insulating pattern 55, the third surface 52c_S3 of the second protrusion portion 52c, the second surface 22_S2 of the interlayered pattern 22 and the second surface IN_S2 of the interposed portion IN may be coplanar with each other. The fourth surface 53_S4 of the first insulating pattern 53 may be connected to the second surface IN_S2 of the interposed portion IN and the third surface 52c_S3 of the second protrusion portion 52c. The fourth surface 55_S4 of the third insulating pattern 55 may be connected to the second surface 22_S2 of the interlayered pattern 22 and the third surface 52c_S3 of the second protrusion portion 52c.

The second protrusion portion 52c may be closer to the bit line BO than the body portion 52a, e.g., in the second direction D2. A distance L1 in the second direction D2 between the body portion 52a and the bit line BO may be greater than a distance L2 in the second direction D2 between the second protrusion portion 52c and the bit line BO. The first protrusion portion 52b may be farther from the bit line BO than the body portion 52a, e.g., in the second direction D2. The first protrusion portion 52b may be farther from the bit line BO than the second protrusion portion 52c, e.g., in the second direction D2.

The first surface 52a_S1 of the body portion 52a and the first surface 52c_S1 of the second protrusion portion 52c may be connected by the third surface 52a_S3 of the body portion 52a. The second surface 52a_S2 of the body portion 52a and the second surface 52c_S2 of the second protrusion portion 52c may be connected by the fourth surface 52a_S4 of the body portion 52a. The first surface 52c_S1 and the second surface 52c_S2 of the second protrusion portion 52c may be connected by the third surface 52c_S3 of the second protrusion portion 52c. The first surface 53_S1 and the second surface 53_S2 of the first insulating pattern 53 may be connected by the third surface 53_S3 and the fourth surface 53_S4 of the first insulating pattern 53. The first surface 55_S1 and the second surface 55_S2 of the third insulating pattern 55 may be connected by the third surface 55_S3 and the fourth surface 55_S4 of the third insulating pattern 55.

A distance in the third direction D3 between the first and second surfaces 52a_S1 and 52a_S2 of the body portion 52a may be greater than a distance in the third direction D3 between the first and second surfaces 52c_S1 and 52c_S2 of the second protrusion portion 52c.

A distance in the third direction D3 between the first surface 52a_S1 of the body portion 52a and the interposed portion IN may be smaller than a distance in the third direction D3 between the first surface 52c_S1 of the second protrusion portion 52c and the interposed portion IN.

A distance in the third direction D3 between the second surface 52a_S2 of the body portion 52a and the interlayered pattern 22 may be smaller than a distance in the third direction D3 between the second surface 52c_S2 of the second protrusion portion 52c and the interlayered pattern22.

Referring to FIG. 2H, the interposed portion IN may further include a third surface IN_S3. The third surface IN_S3 of the interposed portion IN may be parallel to the second direction D2 and the third direction D3.

The body portion 52a may further include a fifth surface 52a_S5. The fifth surface 52a_S5 of the body portion 52a may be parallel to the second direction D2 and the third direction D3.

The fifth surface 52a_S5 of the body portion 52a may be in contact with (e.g., in physical contact with) the third surface IN_S3 of the interposed portion IN. The fifth surface 52a_S5 of the body portion 52a may be a surface of the connection portion 52a3 of the body portion 52a.

Referring to FIG. 2J, the second protrusion portion 52c may further include a fourth surface 52c_S4. The fourth surface 52c_S4 of the second protrusion portion 52c may be parallel to the second direction D2 and the third direction D3. The fourth surface 52c_S4 of the second protrusion portion 52c may be a surface of the connection portion 52c3 of the second protrusion portion 52c.

The first insulating pattern 53 may further include a fifth surface 53_S5 and a sixth surface 53_S6. The fifth surface 53_S5 and the sixth surface 53_S6 of the first insulating pattern 53 may be parallel to the second direction D2 and the third direction D3.

The fourth surface 52c_S4 of the second protrusion portion 52c may be in contact with (e.g., in physical contact with) the fifth surface 53_S5 of the first insulating pattern 53. The sixth surface 53_S6 of the first insulating pattern 53 may be in contact with (e.g., in physical contact with) the third surface IN_S3 of the interposed portion IN.

Because the gate pattern 52 includes the first protrusion portion 52b and the second protrusion portion 52c in the semiconductor device according to some example embodiments, the gate pattern 52 may have a relatively large volume. Because the gate pattern 52 having a relatively great effective work-function, e.g., a greater effective work-function than the work-function pattern 51, has the relatively large volume, resistance of the word line structures WO may be reduced. For example, the relatively large volume of the gate pattern 52 having a greater effective work-function than the work-function pattern 51 may reduce resistance of the word line structure WO when compared with conventional word line structures. Resistance of the word line structures WO may be reduced with the inclusion of only one of the first and second protrusion portions 52b, 52c.

Semiconductor devices according to some example embodiments may include the first insulating pattern 53 in contact with (e.g., in physical contact with) the gate insulating layer 21, e.g., the interposed portion IN, in a part in which the word line structure WO is adjacent to the bit line BO. Because the first insulating pattern 53 is provided instead of the gate pattern 52 having the relatively large effective work-function, leakage may be reduced in a connection portion of the bit line BO and the channel pattern CL. The first insulating pattern 53 may be in contact with (e.g., in physical contact with) the gate insulating layer 21, and in contact with (e.g., in physical contact with) the bit line BO.

Semiconductor devices according to some example embodiments may include the work-function pattern 51 in contact with (e.g., in physical contact with) the gate insulating layer 21 in a part in which the word line structure WO is adjacent to the data storage structure DS. Because the work-function pattern 51 is provided instead of the gate pattern 52 having the relatively large effective work-function, leakage may be reduced in a connection portion between the data storage structure DS and the channel pattern CL. The work-function pattern 51 may be in contact with (e.g., in physical contact with) the gate insulating layer 21, and in contact with (e.g., in physical contact with) the data storage structure DS.

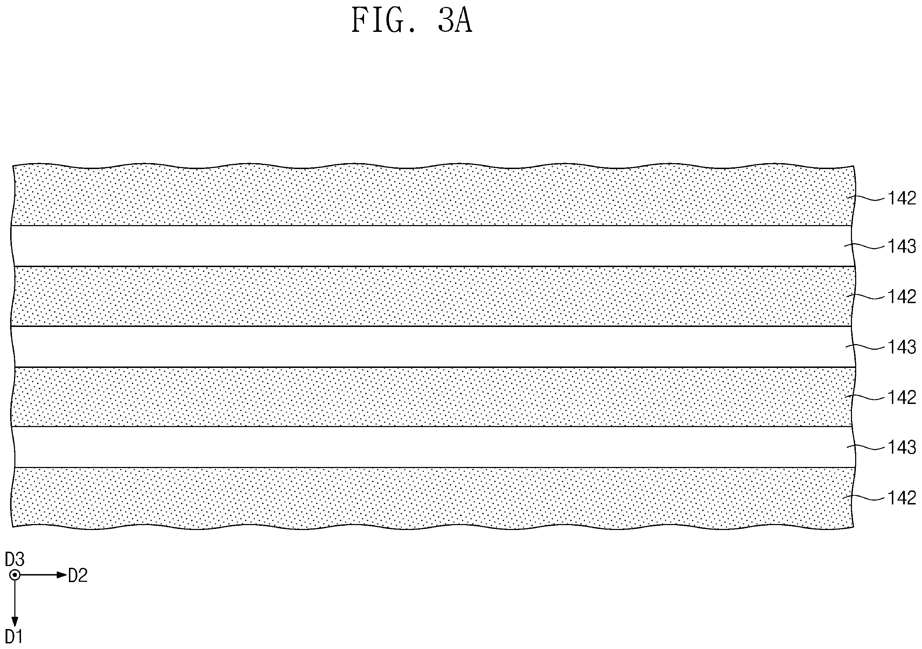

FIGS. 3A, 3B, 3C, 4A, 4B, 4C, 5A, 5B, 5C, 6A, 6B, 6C, 7A, 7B, 8A, 8B, 8C, 9A, 9B, 9C, 10, 11, 12A, 12B, 13, 14A, 14B and 15 are diagrams for describing a method for manufacturing a semiconductor device according to FIGS. 2A to 2I, according to an example embodiment.

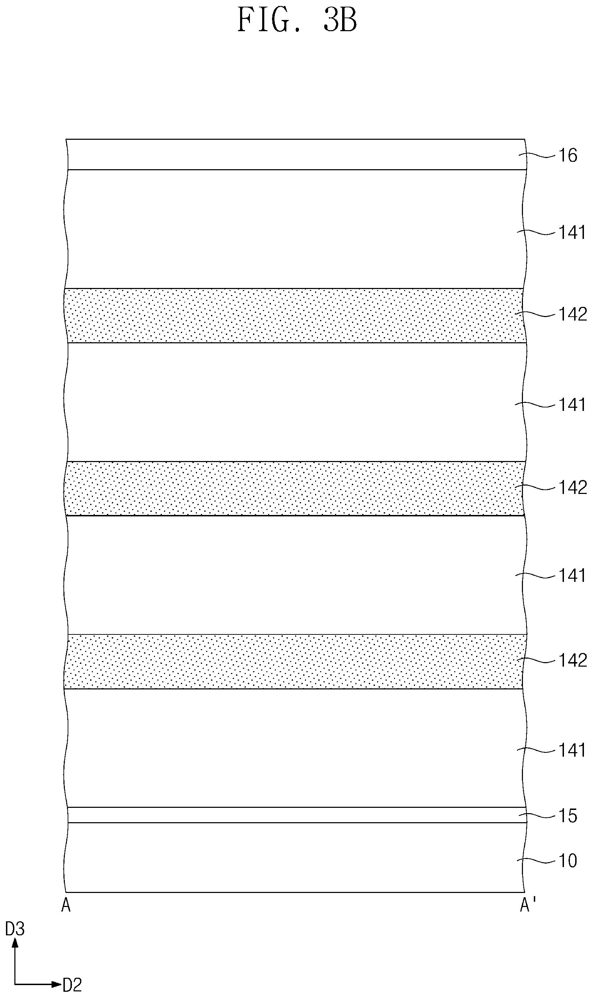

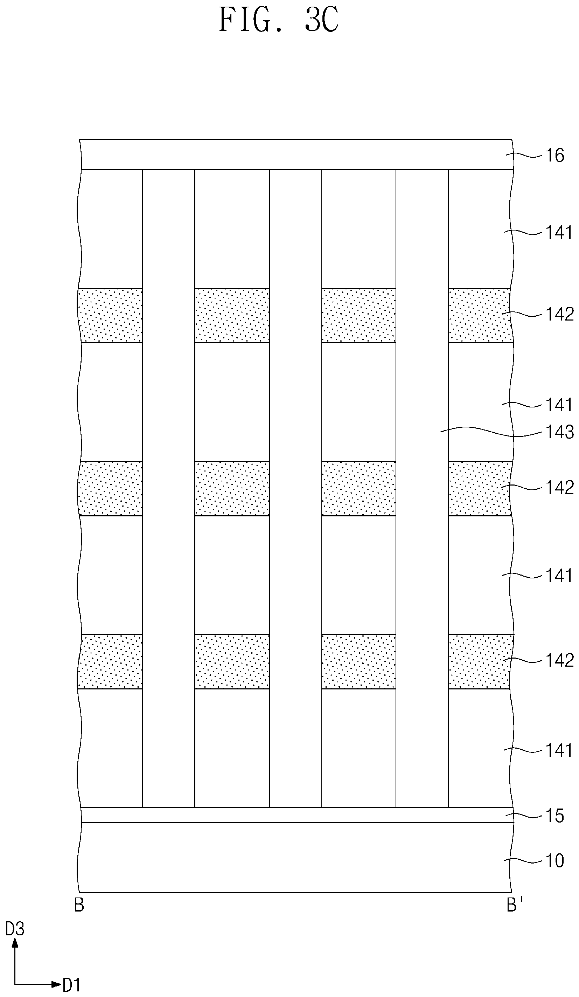

Referring to FIGS. 3A, 3B and 3C, a substrate 10 may be formed. A lower insulating layer 15 may be formed on the substrate 10. Sacrificial layers 141 and preliminary channel layers 142 may be formed on the lower insulating layer 15. The sacrificial layers 141 and the preliminary channel layers 142 may be alternately stacked along the third direction D3. The sacrificial layer 141 and the preliminary channel layer 142 may have etching selectivity with reference to each other. For example, the preliminary channel layer 142 may include silicon, and the sacrificial layer 141 may include silicon-germanium.

Separation patterns 143 extending in the third direction D3 to penetrate the sacrificial layers 141 and the preliminary channel layers 142 may be formed. The separation pattern 143 may extend in the second direction D2. The preliminary channel layer 142 may be divided into a plurality of preliminary channel layers 142 arranged in the first direction D1 by the separation patterns 143. The sacrificial layer 141 may be divided into a plurality of sacrificial layers 141 arranged in the first direction D1 by the separation patterns 143. The separation pattern 143 may include an insulating material. According to some example embodiments, the separation pattern 143 may be multiple layers including a plurality of insulating layers.

An upper insulating layer 16 may be formed on the sacrificial layers 141 and the separation patterns 143.

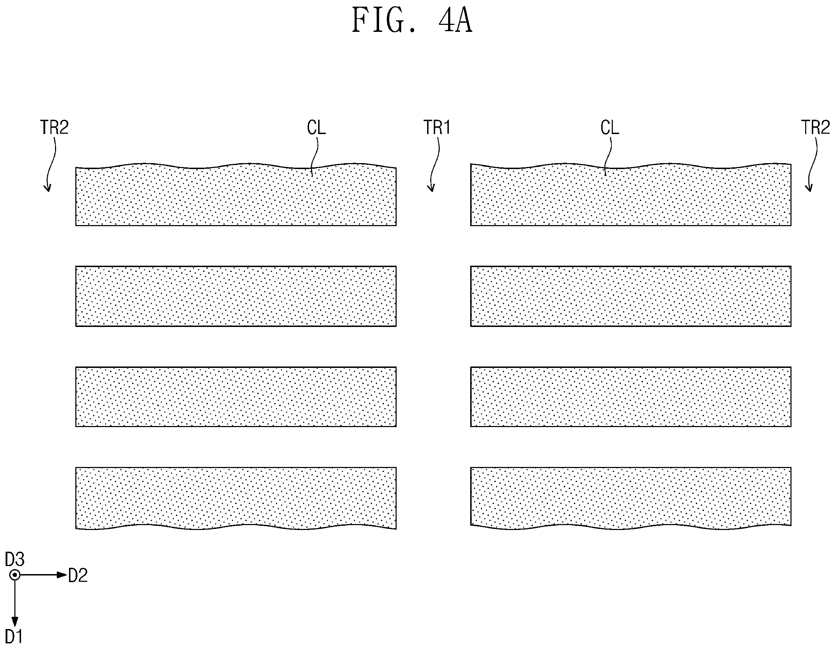

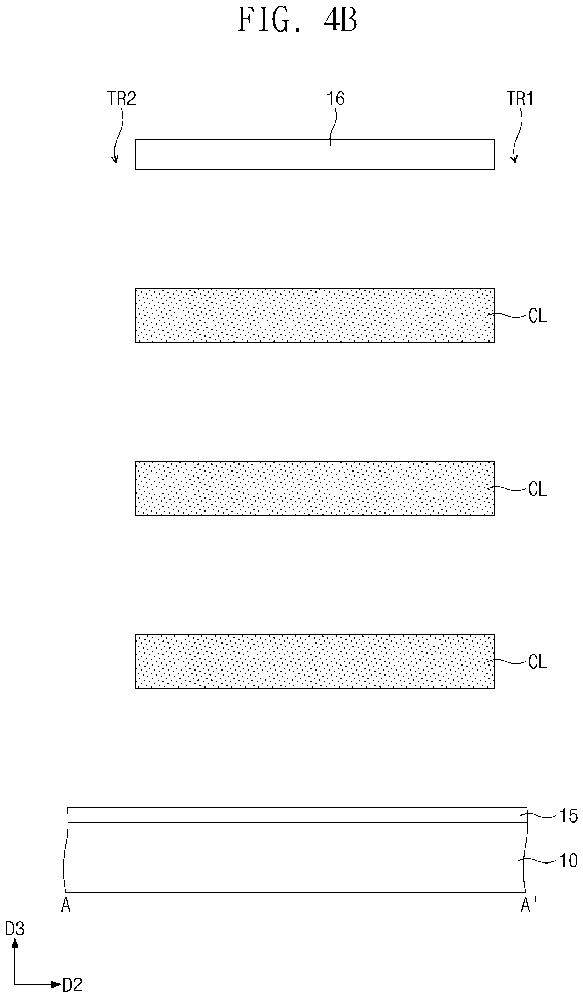

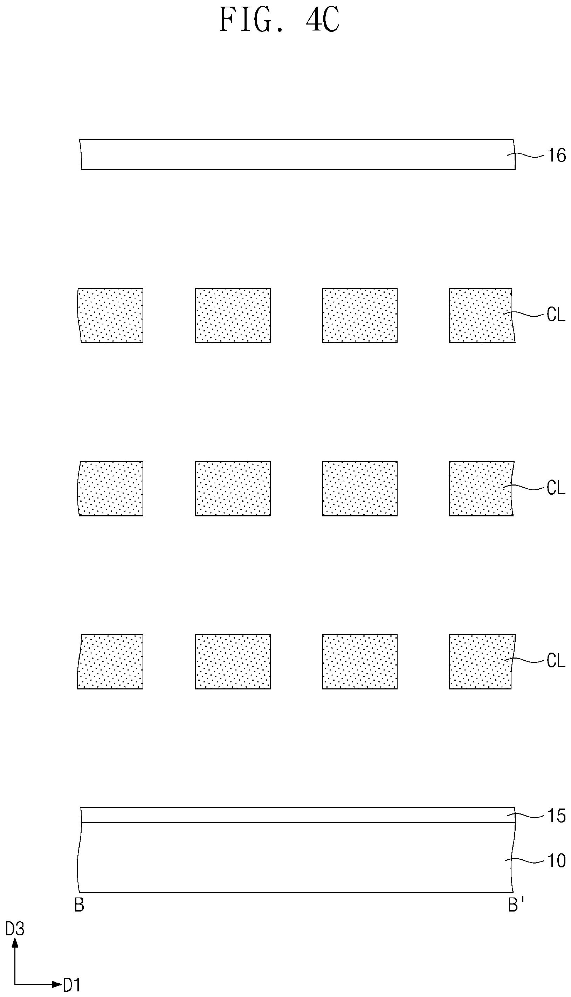

Referring to FIGS. 4A, 4B and 4C, a first trench TR1 and a second trench TR2 extending in the third direction D3 to penetrate the upper insulating layer 16, the sacrificial layers 141, the preliminary channel layers 142 and the separation patterns 143 may be formed. The first and second trenches TR1 and TR2 may extend in the first direction D1. The first and second trenches TR1 and TR2 may be arranged spaced apart from each other in the second direction D2. The first trench TR1 may be disposed between the second trenches TR2.

The preliminary channel layer 142 may be divided into channel patterns CL by the first and second trenches TR1 and TR2.

The sacrificial layers 141 and the separation patterns 143 may be removed through the first and second trenches TR1 and TR2. According to some example embodiments, removing the sacrificial layers 141 and the separation patterns 143 may include selectively removing the sacrificial layers 141, and selectively removing the separation patterns 143.

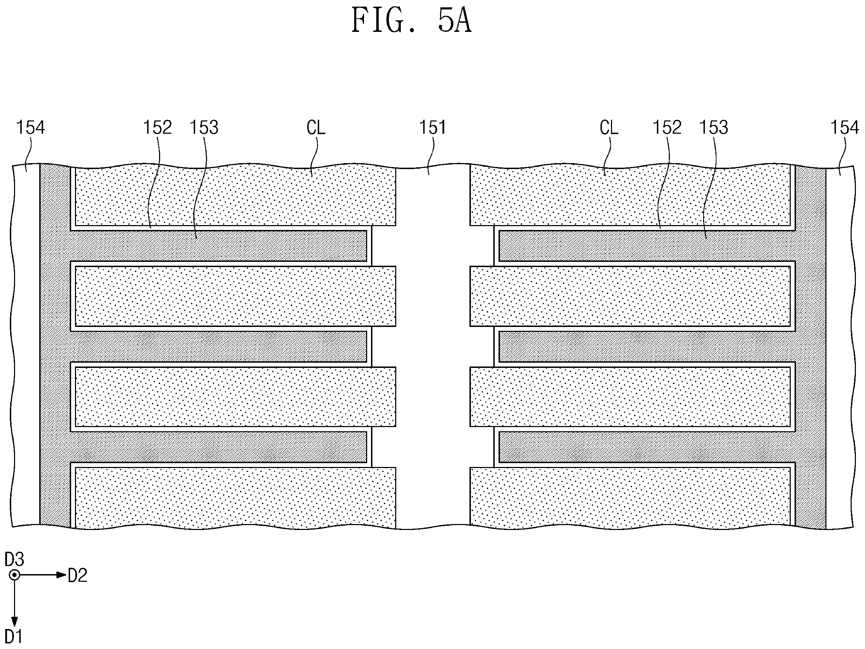

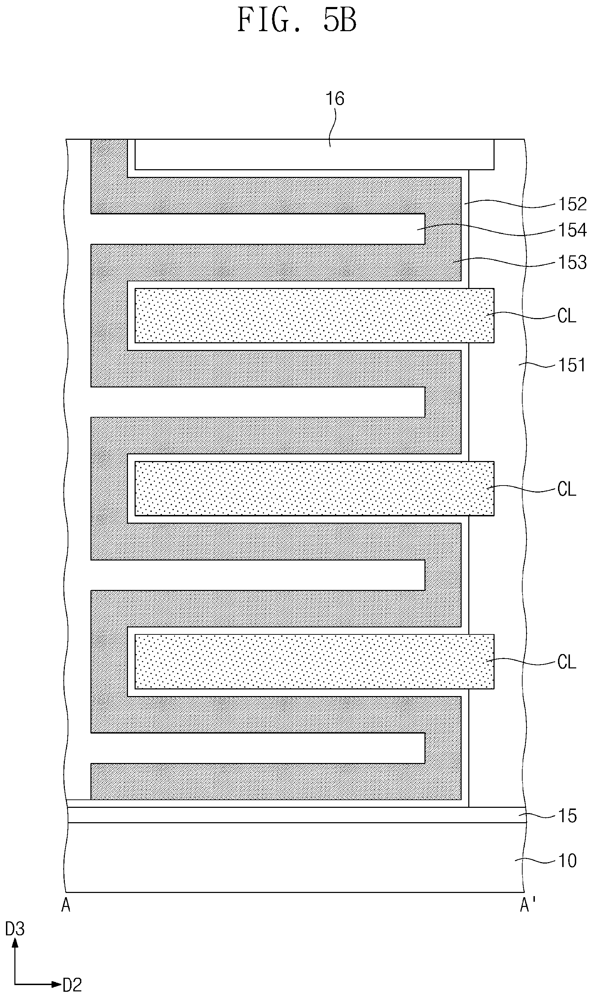

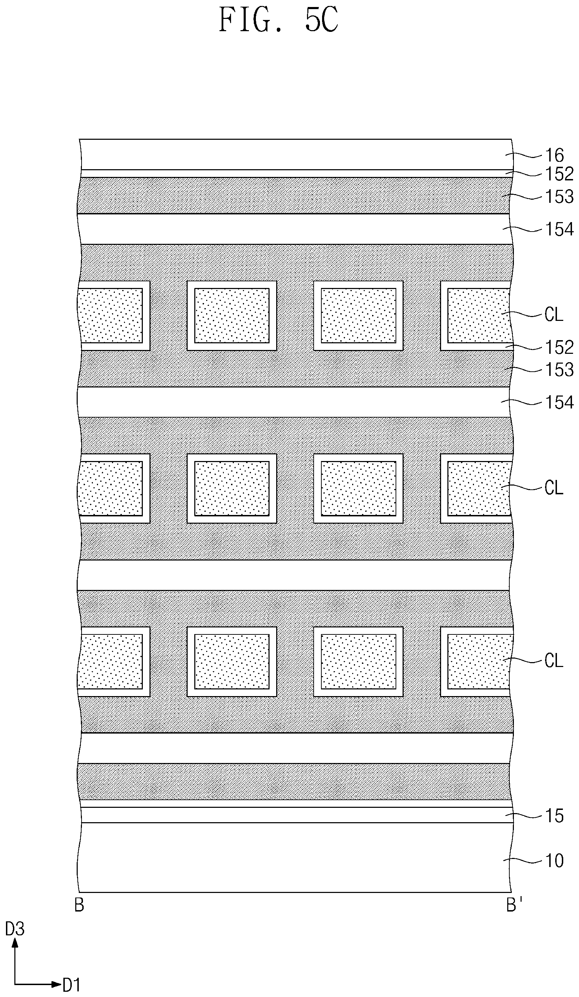

Referring to FIGS. 5A, 5B and 5C, a preliminary interposed pattern layer 151 may be formed through the first trench TR1. The preliminary interposed pattern layer 151 may include an insulating material.

A preliminary gate insulating layer 152, a preliminary filling pattern 153 and a preliminary interlayered pattern 154 may be sequentially formed. The preliminary gate insulating layer 152, the preliminary filling pattern 153 and the preliminary interlayered pattern 154 may be formed through the second trench TR2. The preliminary gate insulating layer 152 and the preliminary filling pattern 153 may be conformally formed. The preliminary filling pattern 153 may include a material having etching selectivity with reference to the preliminary gate insulating layer 152 and the preliminary interlayered pattern 154. For example, the preliminary filling pattern 153 may include nitride, and the preliminary gate insulating layer 152 and the preliminary interlayered pattern 154 may include oxide.

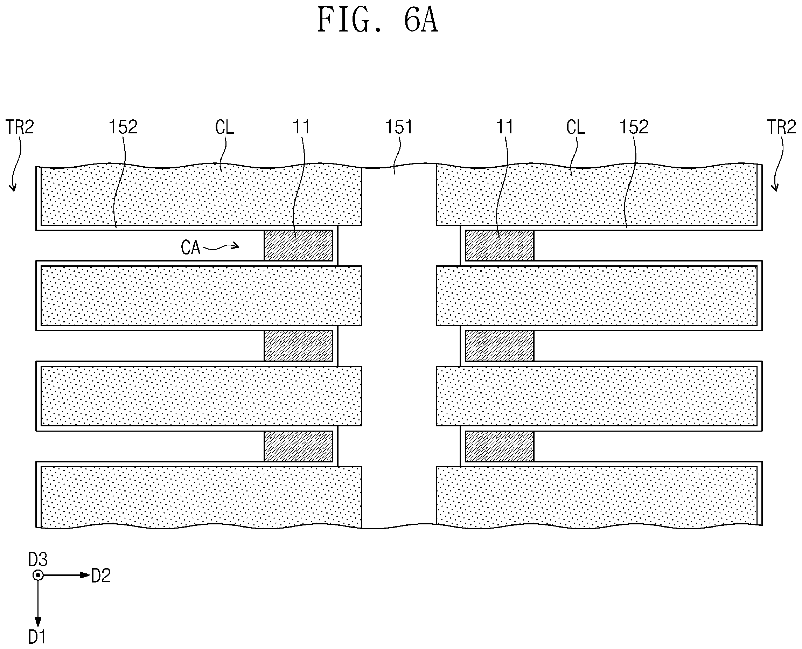

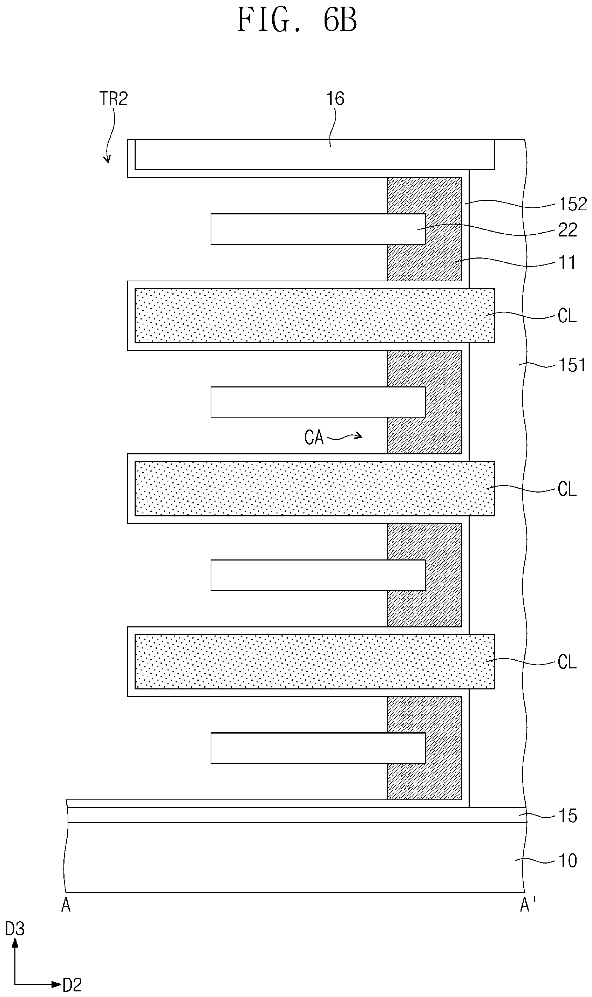

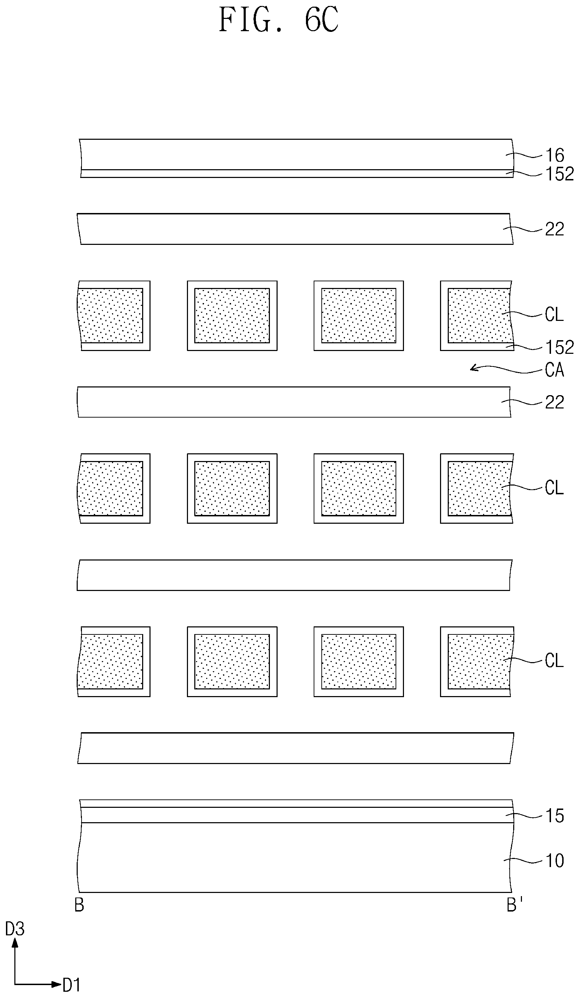

Referring to FIGS. 6A, 6B and 6C, the preliminary interlayered pattern 154 may be etched. For example, the preliminary interlayered pattern 154 may be selectively etched. The preliminary interlayered pattern 154 may be etched to form interlayered patterns 22. The preliminary interlayered pattern 154 may be etched to expose the preliminary filling pattern 153 through the second trench TR2.

The preliminary filling pattern 153 may be etched. For example, the preliminary filling pattern 153 may be selectively etched. The preliminary filling pattern 153 may be etched to form filling patterns 11. Empty spaces formed by etching the preliminary filling pattern 153 may be defined as cavities CA.

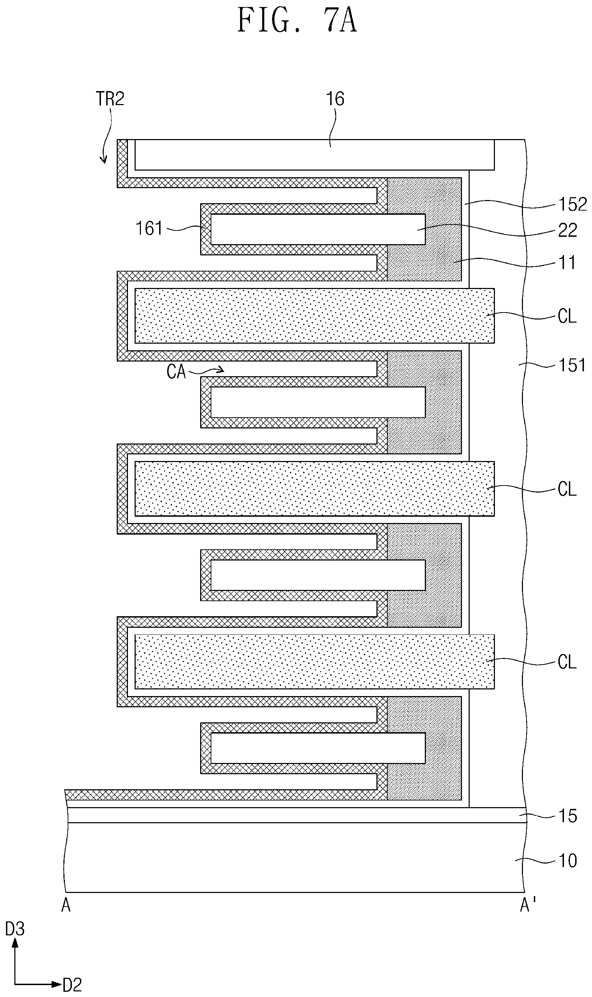

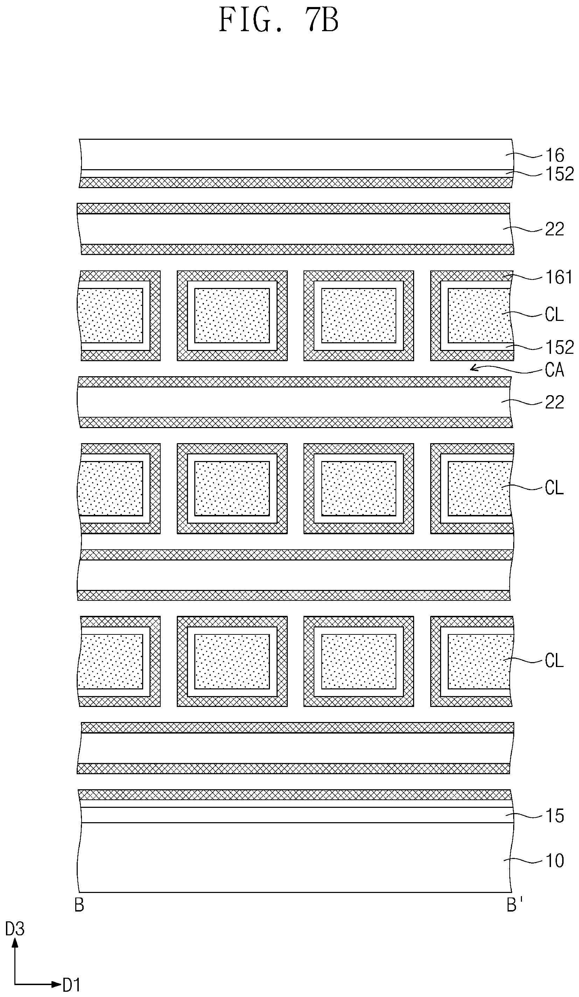

Referring to FIGS. 7A and 7B, a preliminary work-function pattern 161 may be formed. The preliminary work-function pattern 161 may be formed on the interlayered patterns 22, the filling patterns 11 and the preliminary gate insulating layer 152. The preliminary work-function pattern 161 may partially fill the cavity CA.

The preliminary work-function pattern 161 may be conformally formed. For example, the preliminary work-function pattern 161 may include polysilicon doped with a P type impurity or TiN doped with La₂O₃.

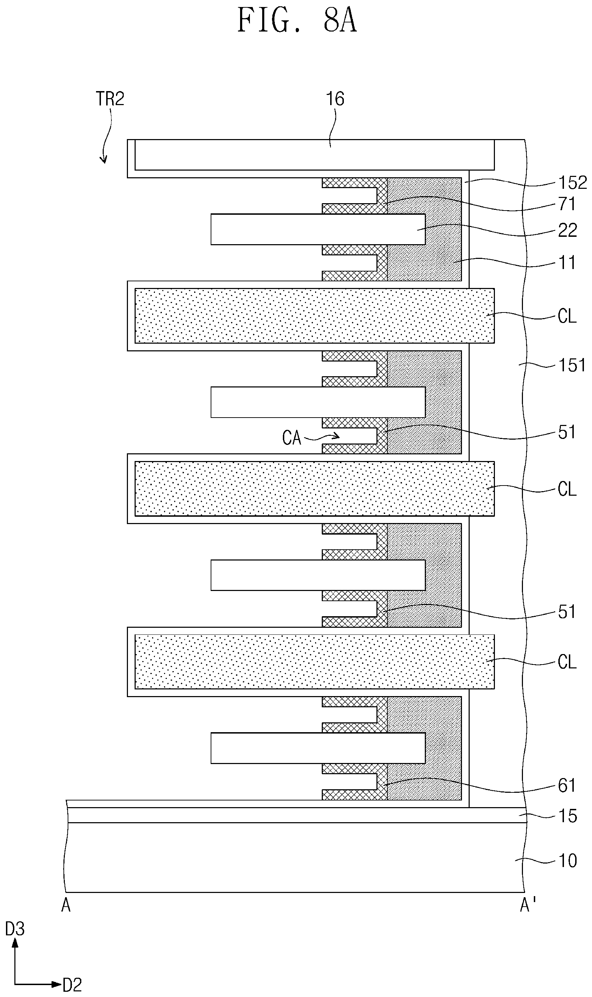

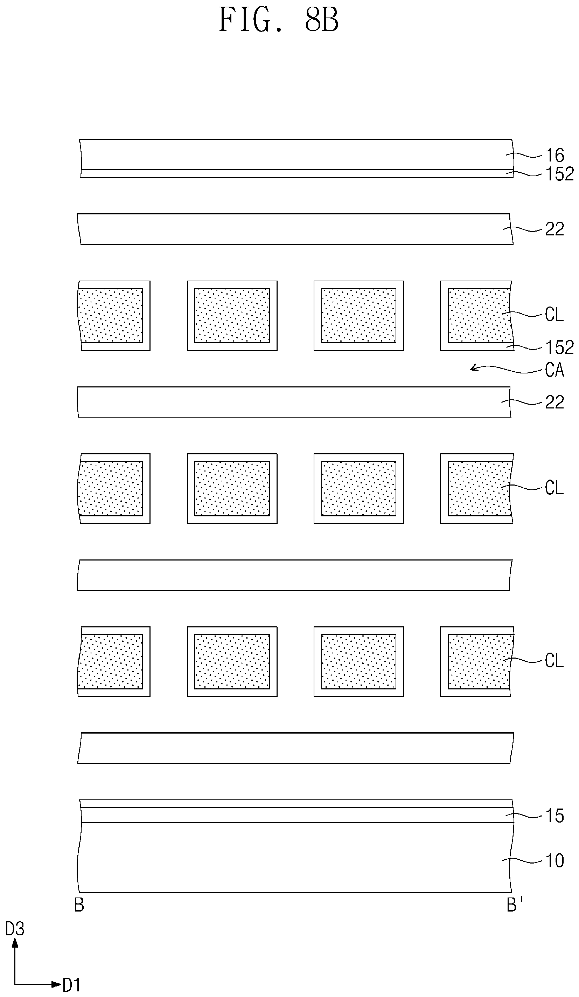

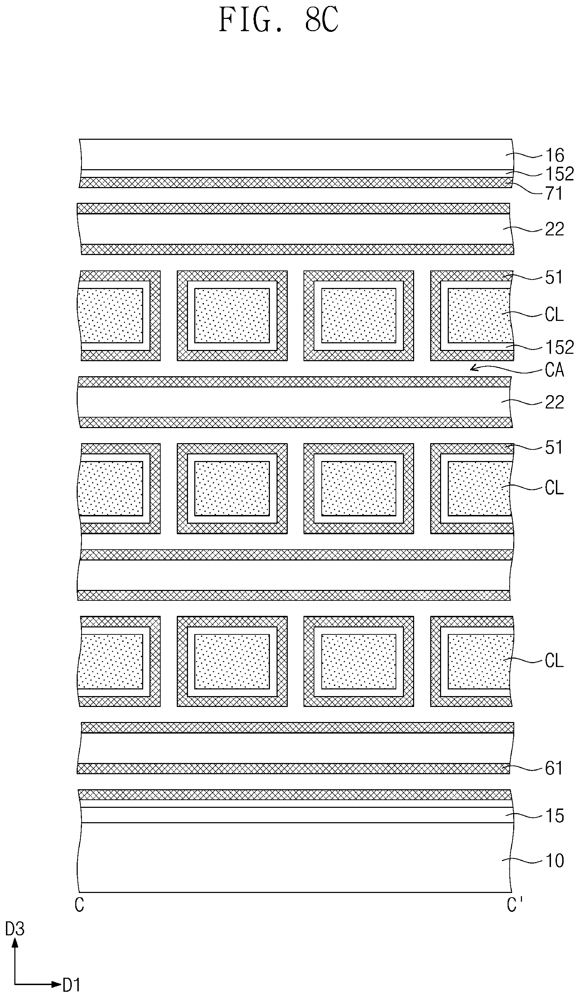

Referring to FIGS. 8A, 8B and 8C, the preliminary work-function pattern 161 may be etched. For example, the preliminary work-function pattern 161 may be selectively etched. For example, the preliminary work-function pattern 161 may be etched in an etch-back process. The preliminary work-function pattern 161 may be etched to form work-function patterns 51, an upper work-function pattern 71 and a lower work-function pattern 61. The preliminary work-function pattern 161 may be divided into the work-function patterns 51, the upper work-function patterns 71 and the lower work-function patterns 61.

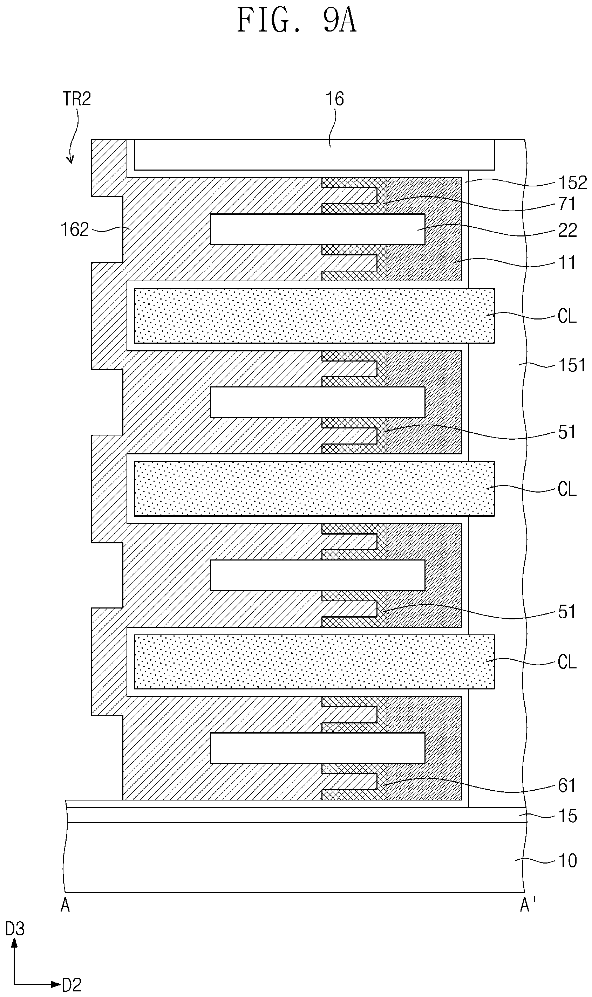

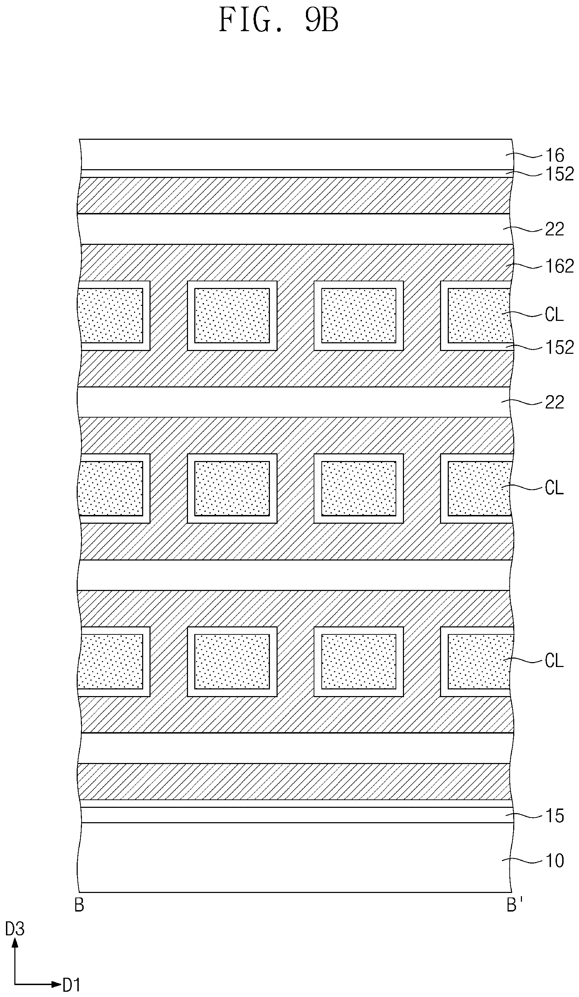

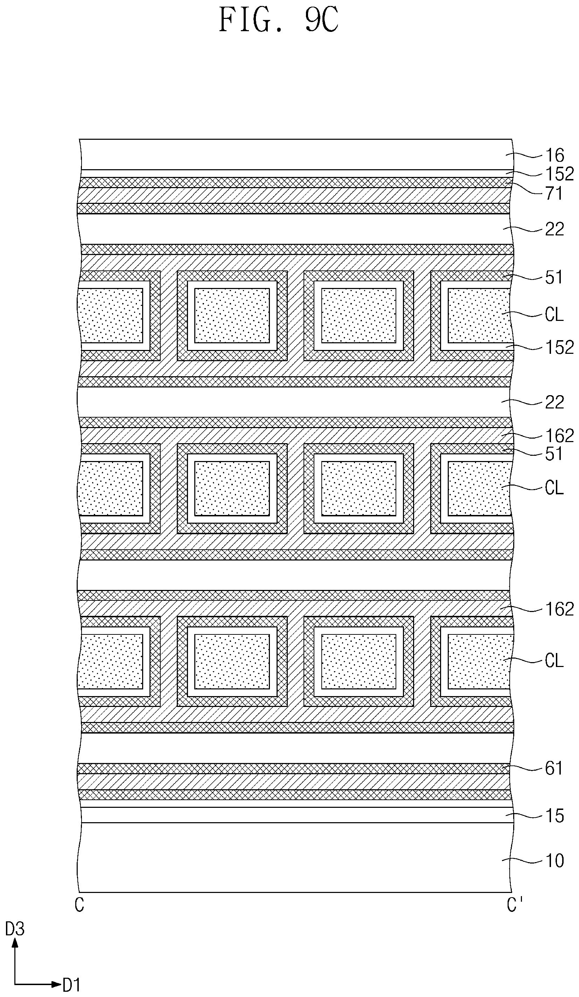

Referring to FIGS. 9A, 9B and 9C, a first preliminary gate layer 162 may be formed. The first preliminary gate layer 162 may be formed on the work-function patterns 51, the upper work-function pattern 71 and the lower work-function pattern 61, the interlayered patterns 22 and the preliminary gate insulating layer 152. The first preliminary gate layer 162 may fill the cavities CA. For example, the first preliminary gate layer 162 may be a TiN layer, a W layer, a Mo layer, or a Ru layer. For example, the first preliminary gate layer 162 may be multiple layers including the TiN layer and the W layer, or multiple layers including the TiN layer and the Mo layer.

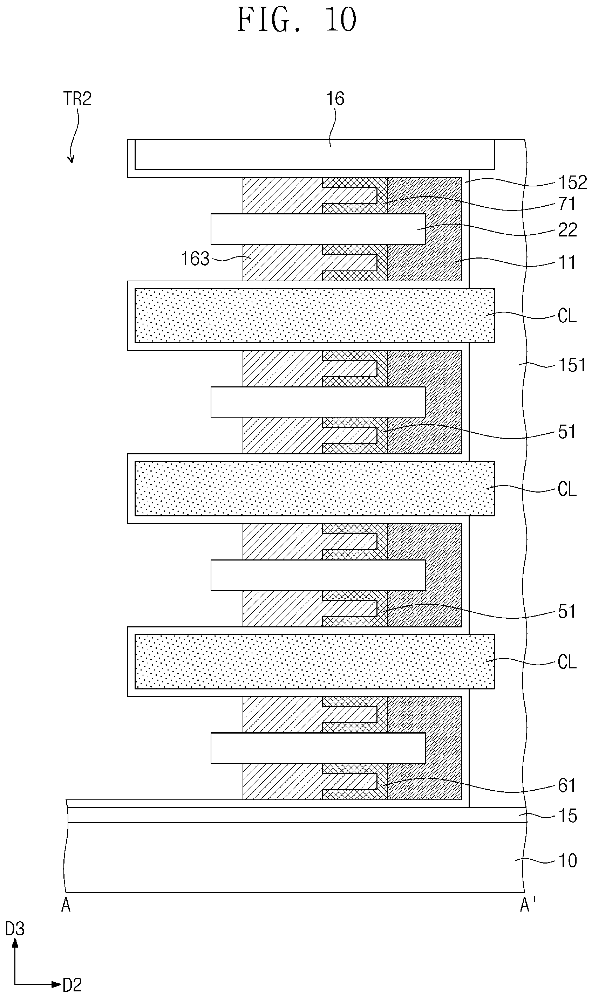

Referring to FIG. 10, the first preliminary gate layer 162 may be etched. For example, the first preliminary gate layer 162 may be selectively etched. For example, the first preliminary gate layer 162 may be etched in an etch-back process. The first preliminary gate layer 162 may be etched to form first preliminary gate patterns 163.

The interlayered pattern 22 may be exposed between the first preliminary gate patterns 163.

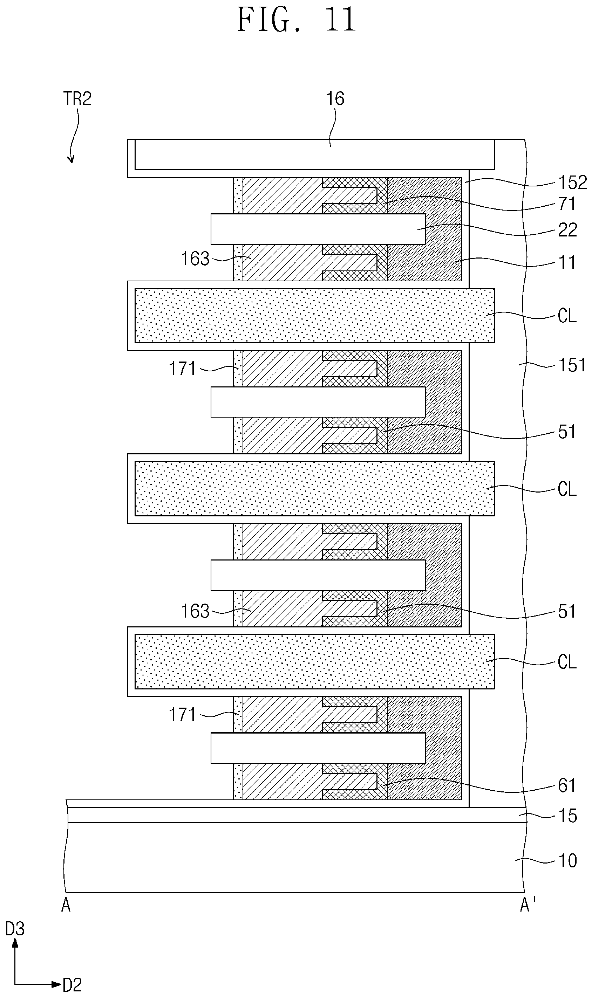

Referring to FIG. 11, selective deposition patterns 171 may be formed. The selective deposition pattern 171 may be selectively formed on the first preliminary gate pattern 163. The selective deposition pattern 171 may not be formed on the interlayered pattern 22 and the preliminary gate insulating layer 152. The selective deposition pattern 171 may include a material selectively deposited on metal. For example, the selective deposition pattern 171 may be a small molecular inhibitor (e.g., SOCl) including S as a head group.

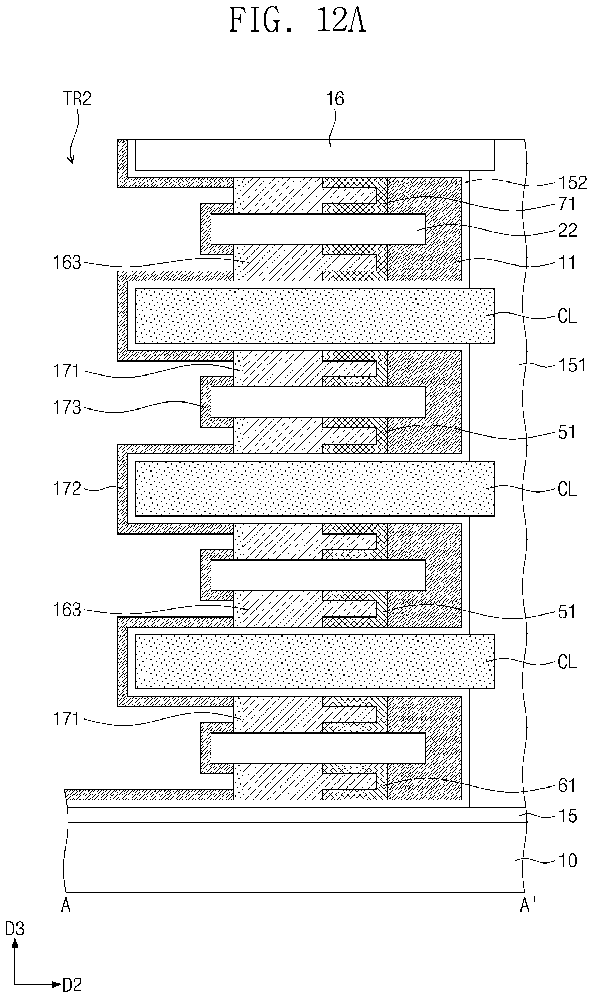

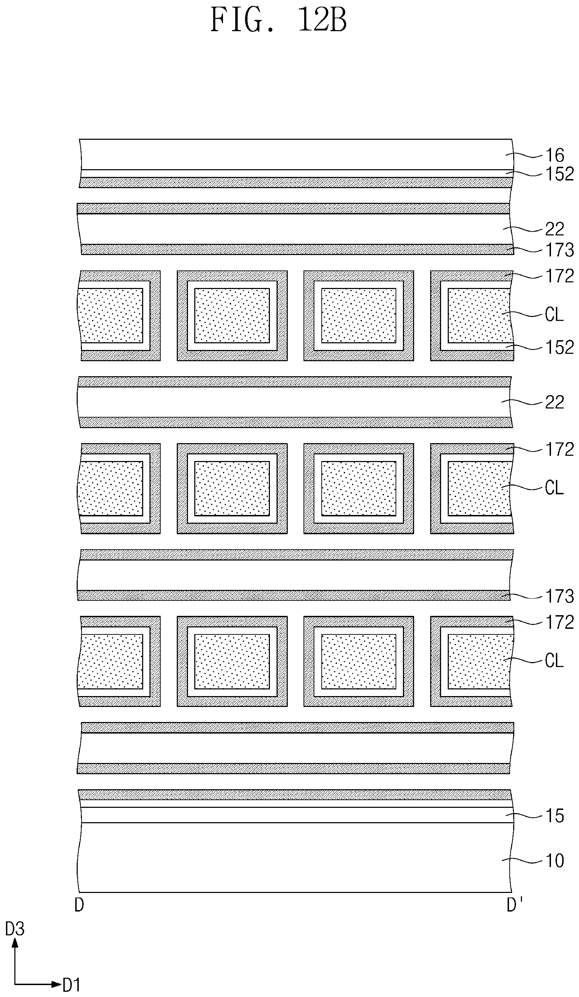

Referring to FIGS. 12A and 12B, a first preliminary insulating patterns 172 and a second preliminary insulating patterns 173 may be formed. The first preliminary insulating pattern 172 may be formed on the preliminary gate insulating layer 152. The second preliminary insulating pattern 173 may be formed on the interlayered pattern 22. The first preliminary insulating patterns 172 and the second preliminary insulating patterns 173 may be simultaneously formed. The first preliminary insulating patterns 172 and the second preliminary insulating patterns 173 may include a high-dielectric material.

The first preliminary insulating patterns 172 and the second preliminary insulating patterns 173 may be selectively formed on an insulating material. The first preliminary insulating patterns 172 and the second preliminary insulating patterns 173 may not be formed on the selective deposition patterns 171. The selective deposition pattern 171 may include a material on which the first preliminary insulating patterns 172 and the second preliminary insulating patterns 173 are not deposited. The first preliminary insulating patterns 172 and the second preliminary insulating patterns 173 may be spaced apart from each other.

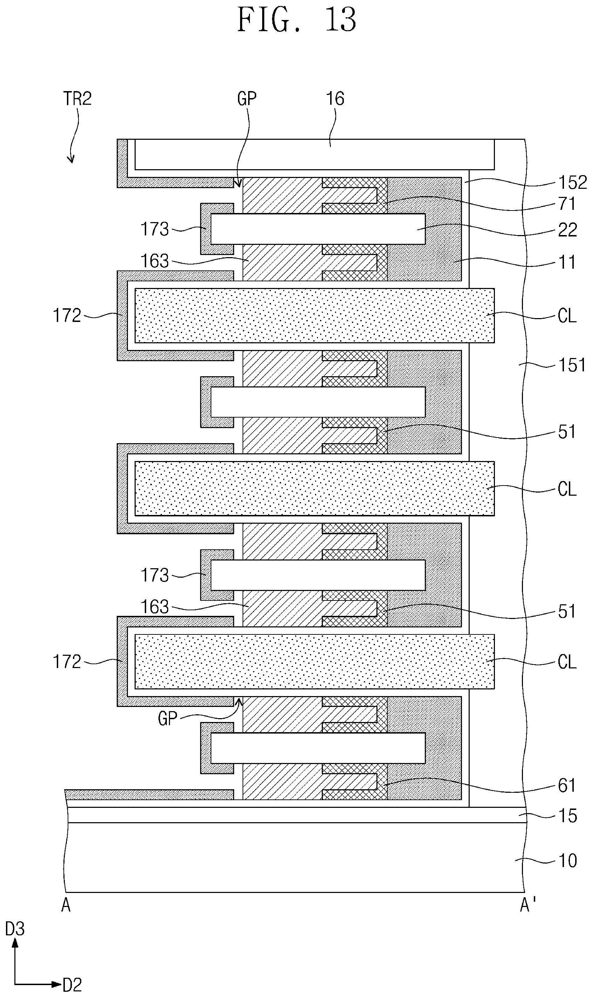

Referring to FIG. 13, the selective deposition patterns 171 may be removed. For example, the selective deposition patterns 171 may be selectively etched. The selective deposition pattern 171 may be removed to form a gap GP, which is an empty space between the first preliminary gate pattern 163 and the first preliminary insulating pattern 172, or between the first preliminary gate pattern 163 and the second preliminary insulating pattern 173.

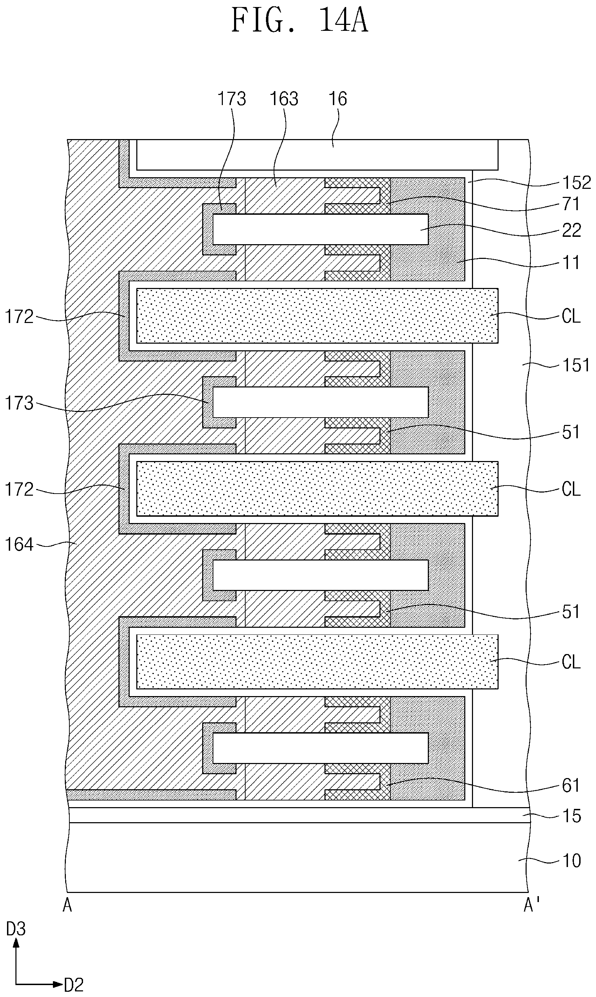

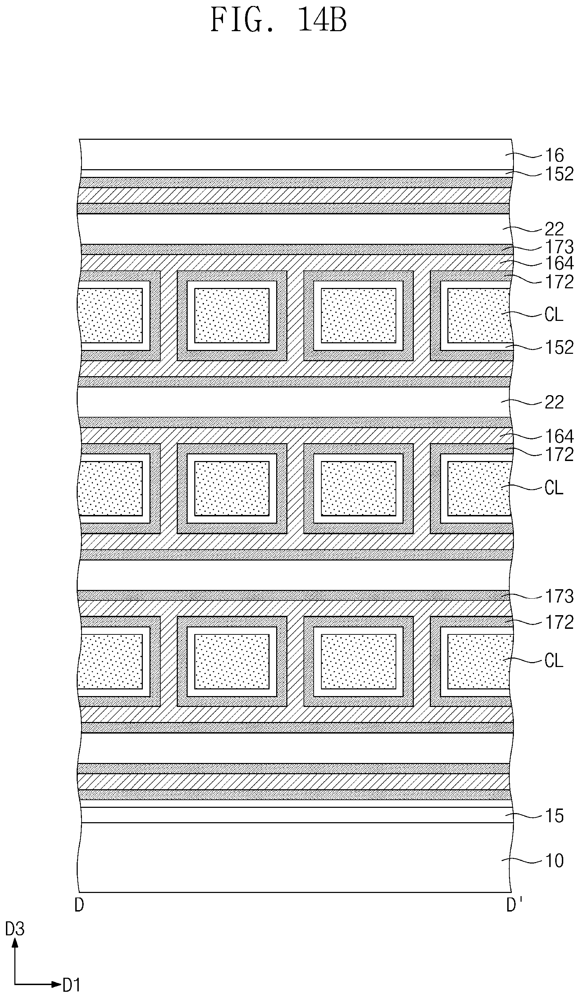

Referring to FIGS. 14A and 14B, a second preliminary gate layer 164 may be formed. The second preliminary gate layer 164 may be formed on the first and second preliminary insulating patterns 172 and 173 and the first preliminary gate pattern 163. The second preliminary gate layer 164 may fill the gaps GP. For example, the second preliminary gate layer 164 may be a TiN layer, a W layer, a Mo layer, or a Ru layer. For example, the second preliminary gate layer 164 may be multiple layers including the TiN layer and the W layer, or multiple layers including the TiN layer and the Mo layer.

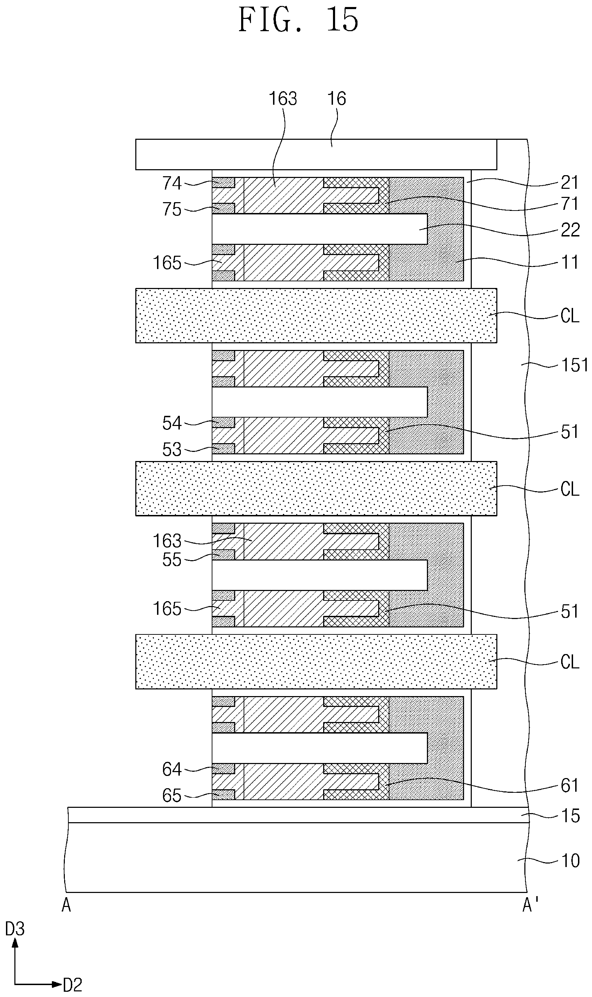

Referring to FIG. 15, the second preliminary gate layer 164, the first and second preliminary insulating patterns 172 and 173 and the preliminary gate insulating layer 152 may be etched.

The second preliminary gate layer 164 may be etched to be divided into second preliminary gate patterns 165. The first preliminary insulating patterns 172 may be etched to form first insulating patterns 53, a first upper insulating pattern 74 and a second lower insulating pattern 65. The second preliminary insulating patterns 173 may be etched to form second and third insulating patterns 54 and 55, a second upper insulating pattern 75 and a first lower insulating pattern 64. The preliminary gate insulating layer 152 may be etched to form gate insulating layers 21.

The second preliminary gate layer 164, the first and second preliminary insulating patterns 172 and 173 and the preliminary gate insulating layer 152 may be etched so that the first to third insulating patterns 53, 54 and 55, the interlayered pattern 22, the gate insulating layer 21 and the second preliminary gate pattern 165 may include surfaces coplanar with each other.

The preliminary gate insulating layer 152 may be etched to expose the channel patterns CL.

Referring to FIGS. 2A to 2E, second interposed patterns 13 may be formed. First conductive patterns 31 and bit lines BO may be formed. Third interposed patterns 14 may be formed. According to some example embodiments, the first conductive patterns 31 may be formed.

The preliminary interposed pattern layer 151 may be etched to form first interposed patterns 12. The preliminary interposed pattern layer 151 may be etched to expose the channel patterns CL.

The channel patterns CL may be etched. Second conductive patterns 32 may be formed on the etched channel patterns CL. A data storage structure DS may be formed on the second conductive patterns 32. According to some example embodiments, the second conductive patterns 32 may not be formed on the etched channel patterns CL.

A gate pattern 52 may be formed by merging the first preliminary gate pattern 163 and the second preliminary gate pattern 165. For example, the first preliminary gate pattern 163 and the second preliminary gate pattern 165 may be merged through an annealing process.

In semiconductor devices according to some example embodiments of the inventive concepts, resistance of a word line structure may be reduced, and/or leakage may be improved in a connection portion of a channel pattern.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

Although some example embodiments of the present inventive concepts have been described with reference to the accompanied drawings, it is understood that the present inventive concepts should not be limited to the example embodiments described above, but various changes and modifications can be made by one ordinary skilled in the art within the scope of the present inventive concepts as hereinafter claimed. Therefore, it should be understood that the example embodiments described above are merely example in all respects and are not intended to be limiting. In addition, example embodiments of the present inventive concepts may be combined with each other.

## Claims

1. A semiconductor device comprising:
a bit line (BO);
a data storage structure (DS) spaced apart from the bit line (BO);
a word line structure (WO) between the bit line (BO) and the data storage structure (DS);
a first channel pattern (CL1) electrically connecting the bit line (BO) and the data storage structure (DS); and
a gate insulating layer (21) including an interposed portion (IN) between the word line structure (WO) and the first channel pattern (CL1), wherein the word line structure (WO) includes:
a gate pattern (52), and
a first insulating pattern (53) between the gate pattern (52) and the interposed portion (IN),
the gate pattern (52) includes,
a body portion (52a) spaced apart from the bit line (BO) in a first direction (D2) with the first insulating pattern (53) therebetween; and
a first protrusion (52c) spaced apart from the interposed portion (IN) in a second direction (D3) with the first insulating pattern (53) therebetween, the second direction (D3) crossing the first direction (D2), and
a distance (L1) in the first direction (D2) between the body portion (52a) and the bit line (BO) is greater than a distance (L2) in the first direction (D2) between the first protrusion (52c) and the bit line (BO).

2. The semiconductor device of claim 1, wherein the first insulating pattern (53) comprises:
a first surface (53_S1) in contact with the interposed portion (IN);
a second surface (53_S1) in contact with the first protrusion (52c); and
a third surface (53_S3) connecting the first surface (53_S1) and the second surface (53_S2) and being in contact with the body portion (52a).

3. The semiconductor device of claim 2, wherein
the body portion (52a) comprises a surface (52a_S1) in contact with the interposed portion (IN), and
the surface (52a_S1) of the body portion (52a) is coplanar with the first surface (53_S1) of the first insulating pattern (53).

4. The semiconductor device of claim 2 or 3, wherein
the first insulating pattern (53) further comprises a fourth surface (53_S4) connecting the first surface (53_S1) and the second surface (53_S2) of the first insulating pattern (53), and
the first protrusion (52c) comprises a surface (52c_S3) coplanar with the fourth surface (53_S4) of the first insulating pattern (53).

5. The semiconductor device of any preceding claim, wherein
the body portion (52a) surrounds the first channel pattern (CL1) and the interposed portion (IN),
the first insulating pattern (53) surrounds the first channel pattern (CL1) and the interposed portion (IN), and
the first protrusion (IN) surrounds the first insulating pattern (53).

6. The semiconductor device of any preceding claim, wherein the word line structure (WO) further comprises a second insulating pattern (55) spaced apart from the first insulating pattern (53) in the second direction (S3) with the first protrusion (52c) therebetween.

7. The semiconductor device of claim 6, wherein the second insulating pattern (55) comprises:
a first surface (55_S2) in contact with the first protrusion (52c); and
a second surface (55_S3) in contact with the body portion (52a),
the first surface (55_S2) of the second insulating pattern (55) is parallel to the first direction (D2), and
the second surface (55_S3) of the second insulating pattern (55) is parallel to the second direction (D3).

8. The semiconductor device of claim 7, wherein
the second insulating pattern (55) further comprises a third surface (55_S1) opposed to the first surface (55_S2) of the second insulating pattern (55), and
the body portion (52a) comprises a surface (52a_S2) coplanar with the third surface (55_S1) of the second insulating pattern (55).

9. The semiconductor device of any preceding claim, wherein
the word line structure (WO) further includes a work-function pattern (51) between the gate pattern (52) and the data storage structure (DS), and
the gate pattern (52) further includes a second protrusion (52b) spaced apart from the interposed portion (IN) with a first part (51a) of the work-function pattern (51) therebetween.

10. The semiconductor device of claim 9, wherein the work-function pattern (51) comprises:
a second part (51b) spaced apart from the first part (51a) of the work-function pattern (51) with the second protrusion (52b) therebetween; and
a third part (51c) connecting the first part (51a) and the second part (51b) of the work-function pattern (51).

11. The semiconductor device of claim 9 or 10, further comprising:
a second channel pattern (CL2) overlapping the first channel pattern (CL1) in the second direction (D3), wherein
the body portion (52a) includes a first line portion (52a1) between the first and second channel patterns (CL1, CL2),
the second protrusion (52b) includes a first line portion (52b1) between the first and second channel patterns (CL1, CL2), and
a width (W1) in the second direction (D3) of the first line portion (52a1) of the body portion (52a) is greater than a width (W2) in the second direction (D3) of the first line portion (52b1) of the second protrusion (52b).

12. The semiconductor device of claim 11, further comprising:
a third channel pattern (CL3) overlapping the first channel pattern (CL1) in the second direction (D3),
wherein the first channel pattern (CL1) is between the second channel pattern (CL2) and the third channel pattern (CL3),
the body portion (52a) further includes a second line portion (52a2) between the first and third channel patterns (CL1, CL3),
the second protrusion (52b) further includes a second line portion (52b2) between the first and third channel patterns (CL1, CL3), and
a width (W1) in the second direction (D3) of the second line portion (52a2) of the body portion (52a) is greater than a width in the second direction (D3) of the second line portion (52b2) of the second protrusion (52b).

13. The semiconductor device of claim 12, further comprising:
a fourth channel pattern (CL4) and a fifth channel pattern (CL5) spaced apart from the first channel pattern (CL1) in a third direction (D1) crossing the first direction (D2) and the second direction (D3),
wherein the body portion (52a) includes connection portions (52a3) between the first, fourth and fifth channel patterns (CL1, CL4, CL5),
the second protrusion (52b) includes connection portions (52b3) between the first, fourth and fifth channel patterns (CL1, CL4, CL5),
the connection portions (52a3) of the body portion (52a) connect the first line portion (52a1) of the body portion (52a) and the second line portion (52a2) of the body portion (52a), and
the connection portions (52b3) of the second protrusion (52b) connect the first line portion (52b1) of the second protrusion (52b) and the second line portion (52b2) of the second protrusion (52b).

14. The semiconductor device of claim 13, wherein a width in the third direction (D1) of each of the connection portions (52a3) of the body portion (52a) is greater than a width in the third direction (D1) of each of the connection portions (52b3) of the second protrusion (52b).

15. The semiconductor device of any of claims 9 to 14, wherein a distance between the interposed portion (IN) and the body portion (52a) is smaller than a distance between the second protrusion (52b) and the interposed portion (IN).
